(19) Europäisches Patentamt
European Patent Office
Office européen des brevets

(11) EP 4 382 290 A1

(12) **EUROPEAN PATENT APPLICATION**
published in accordance with Art. 153(4) EPC

(43) Date of publication:
**12.06.2024 Bulletin 2024/24**

(21) Application number: **22852900.4**

(22) Date of filing: **26.07.2022**

(51) International Patent Classification (IPC):
***B32B 9/00*** *(2006.01)* ***B32B 27/30*** *(2006.01)*
***C08G 65/323*** *(2006.01)* ***C08G 65/328*** *(2006.01)*

(52) Cooperative Patent Classification (CPC):
**B32B 9/00; B32B 27/30; C08G 65/323; C08G 65/328**

(86) International application number:
**PCT/JP2022/028769**

(87) International publication number:
**WO 2023/013477 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.08.2021 JP 2021128691**

(71) Applicant: **SHIN-ETSU CHEMICAL CO., LTD.**
**Tokyo 1000005 (JP)**

(72) Inventors:
- **UCHIDA Takashi**
**Annaka-shi, Gunma 379-0224 (JP)**
- **HAYASHI Ryuto**
**Annaka-shi, Gunma 379-0224 (JP)**
- **YAMANE Yuji**
**Annaka-shi, Gunma 379-0224 (JP)**

(74) Representative: **Ter Meer Steinmeister & Partner Patentanwälte mbB**
**Nymphenburger Straße 4**
**80335 München (DE)**

# (54) ARTICLE HAVING WATER- AND OIL-REPELLENT SURFACE LAYER

(57) The present invention provides an article having a water- and oil-repellent surface layer, as well as excellent water- and oil-repellent properties, abrasion resistance, and slipperiness, said article being constituted from: a plastic substrate; an underlayer formed upon the outer surface of the plastic substrate and having a silicon oxide as the main component thereof; and a water- and oil-repellent surface layer formed upon the outer surface of the silicon oxide underlayer. The film density of the silicon oxide underlayer is 1.8-2.2 g/cm$^3$. The film thickness of the silicon oxide underlayer is 80-300 nm. The water- and oil-repellent surface layer has, as the main component thereof: a fluoropolyether group-containing polymer having a hydrolyzable silyl group with a specific structure; and/or a cured product of a partially hydrolyzed condensate thereof.

EP 4 382 290 A1

## Description

### TECHNICAL FIELD

This invention relates to an article comprising a plastic substrate and a water/oil repellent surface layer having excellent water/oil repellent, abrasion resistant, and glide properties.

### BACKGROUND ART

When coated and cured to the surface of substrates of metals, porcelain, glass, or plastics, fluoropolyether-containing polymers form a water/oil repellent layer (antifouling coating thin layer) on the surface of the substrates to provide the substrates with an ability to prevent oil and fat staining, fingerprint staining and otherwise staining. Specifically, fluoropolyether-containing polymers are used to form an antifouling coating thin layer on the surface of touch panel displays of portable electronic terminals, terminal casings or other parts (see Patent Documents 1 to 6: JP 6260579, JP 6828744, JP 5761305, JP 6451279, JP 6741074, and JP 6617853).

For the antifouling coating thin layer on the touch panel display surface, not only the antifouling properties, but also the feeling on swiping of the touch panel (smooth gliding and comfortable touch feeling) are considered important. Good feeling on swiping corresponds to a low coefficient of friction (see Patent Document 4: JP 6451279).

Since the water/oil repellent surface layer is subject to friction and abrasion by fingers, clothing and stylus pens during service and thus loses water/oil repellent and antifouling properties, an underlayer of silicon oxide is formed below the water/oil repellent surface layer for providing durability (see Patent Documents 7 to 13: WO 2014/097388, JP-A 2020-132498, JP-A 2020-090652, JP 5655215, JP 6601492, JP 5494656, and WO 2019/035271).

The use of the silicon oxide underlayer, however, sometimes fails to establish sufficient abrasion durability.

### PRIOR ART DOCUMENTS

### PATENT DOCUMENTS

Patent Document 1: JP 6260579
Patent Document 2: JP 6828744
Patent Document 3: JP 5761305
Patent Document 4: JP 6451279
Patent Document 5: JP 6741074
Patent Document 6: JP 6617853
Patent Document 7: WO 2014/097388
Patent Document 8: JP-A 2020-132498
Patent Document 9: JP-A 2020-090652
Patent Document 10: JP 5655215
Patent Document 11: JP 6601492
Patent Document 12: JP 5494656
Patent Document 13: WO 2019/035271
Patent Document 14: JP 6569831
Patent Document 15: JP-A 2011-116947
Patent Document 16: JP-A 2007-197425
Patent Document 17: JP-A 2007-297589
Patent Document 18: JP-A 2007-297543
Patent Document 19: JP-A 2008-088412
Patent Document 20: JP-A 2008-144144
Patent Document 21: JP-A 2010-031184
Patent Document 22: JP-A 2010-047516
Patent Document 23: JP-A 2011-178835
Patent Document 24: JP-A 2014-084405
Patent Document 25: JP-A 2014-105235
Patent Document 26: JP-A 2013-253228
Patent Document 27: JP-A 2014-218639
Patent Document 28: WO 2013/121984

Patent Document 29: JP-A 2007-011033

## SUMMARY OF INVENTION

## TECHNICAL PROBLEM

An object of the invention, which has been made under the above-mentioned circumstances, is to provide an article comprising a plastic substrate and a water/oil repellent surface layer thereon having excellent water/oil repellent, abrasion resistant, and gliding properties.

## SOLUTION TO PROBLEM

Making extensive investigations to attain the above object, the inventors found that an article comprising a plastic substrate, an underlayer formed mainly of silicon oxide on the outer surface of the plastic substrate, and a water/oil repellent surface layer formed on the outer surface of the underlayer fails to exhibit satisfactory abrasion durability when the silicon oxide underlayer has a high film density.

Continuing further investigations, the inventors have found that when the silicon oxide underlayer has a film density of 1.8 to 2.2 g/cm$^3$ and a film thickness of 80 to 300 nm, and the water/oil repellent surface layer is formed mainly of a cured product of a fluoropolyether-containing polymer having a hydrolyzable silyl group and/or a partial hydrolytic condensate thereof, and the fluoropolyether-containing polymer having a hydrolyzable silyl group contains a fluoropolyether-containing polymer of a specific structure to be described later, the resulting water/oil repellent surface layer has excellent water/oil repellency, abrasion durability, and gliding properties.

Accordingly, the invention provides an article having a water/oil repellent surface layer as defined below.

[1] An article comprising a plastic substrate, an underlayer formed mainly of silicon oxide on the outer surface of the plastic substrate, and a water/oil repellent surface layer formed on the outer surface of the underlayer, wherein the silicon oxide underlayer has a film density of 1.8 to 2.2 g/cm$^3$ and a film thickness of 80 to 300 nm, the water/oil repellent surface layer is based on a cured product of a fluoropolyether-containing polymer having a hydrolyzable silyl group and/or a partial hydrolytic condensate thereof, and the fluoropolyether-containing polymer having a hydrolyzable silyl group contains at least one fluoropolyether-containing polymer having the formula (1), (4) or (7):
[Chem. 1]

$$A^1\text{-Rf-D} \qquad (1)$$

wherein Rf is a divalent polyfluorooxyalkylene structure-containing group: $-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, p, q, r, s, t, and u are each independently an integer of 0 to 150, the sum of p, q, r, s, t, and u is an integer of 1 to 250, each unit may be straight or branched, the repeating units in parentheses with subscripts p, q, r, s, t, and u may be randomly arranged, $A^1$ is a monovalent fluorinated hydrocarbon group which is terminated with $CF_3$- or $CF_2H$- and may contain oxygen, or D, D is independently a monovalent group having the formula (2):
[Chem. 2]

$$-Q-Z(W)_{\alpha} \qquad (2)$$

wherein Q is a single bond or a divalent organic group, Z is a tri- to octavalent group, $\alpha$ is an integer of 2 to 7, W is independently a monovalent hydrolyzable silyl-containing group having the formula (3):

[Chem. 3]

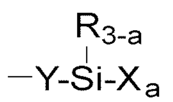
(3)

wherein R is a $C_1$-$C_4$ alkyl group or phenyl group, X is independently a hydrolyzable group, a is 2 or 3, Y is a single bond or a divalent hydrocarbon group which may contain at least one moiety selected from fluorine, silicon and siloxane bond,
[Chem. 4]

$A^2$-Rf-G (4)

wherein Rf is as defined above, $A^2$ is a monovalent fluorinated hydrocarbon group which is terminated with $CF_3$- or $CF_2H$- and may contain oxygen, or G, G is independently a monovalent group having the formula (5):

[Chem. 5]

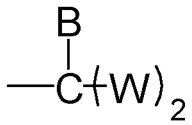

(5)

wherein W is as defined above, B is hydrogen or -OS, S is hydrogen, a $C_1$-$C_{10}$ monovalent hydrocarbon group, or a monovalent group having the formula (6):

[Chem. 6]

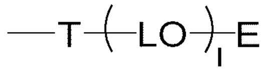

(6)

wherein T is a single bond or divalent group, L is independently a $C_1$-$C_4$ divalent hydrocarbon group, E is a $C_1$-$C_6$ monovalent hydrocarbon group or W, l is an integer of 0 to 20,
[Chem. 7]

$A^3$-Rf-J (7)

wherein Rf is as defined above, $A^3$ is a monovalent fluorinated hydrocarbon group which is terminated with $CF_3$- or $CF_2H$- and may contain oxygen, or J, J is independently a monovalent group having the formula (8):

[Chem. 8]

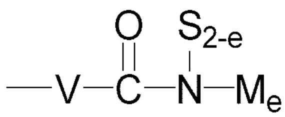

(8)

wherein S is as defined above, V is a single bond or a $C_2$-$C_{15}$ divalent hydrocarbon group which may contain an ether bond, M is independently a monovalent group having the formula (9):

[Chem. 9]

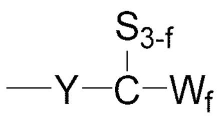

(9)

wherein Y, S, and W are as defined above, f is an integer of 1 to 3, and e is 1 or 2, J containing at least two W.
[2] The article of [1] wherein in formula (2), Q is a $C_1$-$C_{15}$ substituted or unsubstituted divalent hydrocarbon group which may contain at least one bond selected from the group consisting of amide bond, ether bond, ester bond, sulfide bond, urethane bond, siloxane bond, triazine bond, diorganosilylene moiety, silphenylene bond and silalkylene bond, and Z is a tri- to octavalent group selected from silicon, nitrogen, and tri- to octavalent organopolysiloxane residues containing a siloxane bond.
[3] The article of [1] wherein in formula (6), T is a single bond or a $C_2$-$C_{20}$ divalent hydrocarbon group which may

contain at least one bond selected from the group consisting of silicon, siloxane bond, silalkylene bond, silarylene bond, and diorganosilylene moiety, a divalent siloxane bond, silalkylene group or diorganosilylene group.

[4] The article of any one of [1] to [3] wherein the water/oil repellent surface layer contains a cured product of at least one fluoropolyether-containing polymer having the formula (1), (4) or (7), and/or a partial hydrolytic condensate thereof, and a fluoropolyether-containing polymer having the formula (10):

[Chem. 10]

$$A^4\text{-}Rf\text{-}A^4 \qquad (10)$$

wherein Rf is a divalent polyfluorooxyalkylene structure-containing group: $-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, p, q, r, s, t, and u are each independently an integer of 0 to 150, the sum of p, q, r, s, t, and u is an integer of 1 to 250, each unit may be straight or branched, the repeating units in parentheses with subscripts p, q, r, s, t, and u may be randomly arranged, and $A^4$ is independently a monovalent fluorinated hydrocarbon group which is terminated with $CF_3$- or $CF_2H$- and may contain oxygen, or $-OR^3$, $-COOR^3$ or $-PO(OR^3)_2$ wherein $R^3$ is hydrogen or a $C_1$-$C_{10}$ monovalent hydrocarbon group, and/or a partial (hydrolytic) condensate thereof.

[5] The article of any one of [1] to [4] wherein the water/oil repellent surface layer is formed by a physical vapor deposition (PVD) method, spraying method or dipping method.

[6] The article of any one of [1] to [5] wherein the plastic substrate has been pretreated by wet cleaning and/or plasma cleaning.

## ADVANTAGEOUS EFFECTS OF INVENTION

The article comprising a plastic substrate, an underlayer formed mainly of silicon oxide on the outer surface of the plastic substrate and having a specific film density and a specific film thickness, and a water/oil repellent surface layer formed on the outer surface of the underlayer and based on a cured product of a fluoropolyether-containing polymer of specific structure having a hydrolyzable silyl group and/or a partial hydrolytic condensate thereof according to the invention exhibits excellent water/oil repellency, abrasion durability, and gliding properties.

## DESCRIPTION OF EMBODIMENTS

The invention provides an article comprising a plastic substrate, a silicon oxide underlayer, and a water/oil repellent surface layer. In particular, the invention is characterized in that the water/oil repellent surface layer is formed on the outer surface of the silicon oxide-based underlayer on the plastic substrate from a surface treating agent containing a fluoropolyether-containing polymer of specific structure having a hydrolyzable silyl group and/or a partial hydrolytic condensate thereof.

[Plastic substrate]

Examples of the plastic used as the substrate include, but are not limited to, thermoplastic organic resins, for example, polycarbonate resins, polyester resins such as polyethylene terephthalate (PET) and polyethylene naphthalate (PEN), polyamide (PA) resins, polyimide (PI) resins, cellulose resins such as triacetyl cellulose, styrene resins such as polystyrene (PS), acrylonitrile-styrene copolymers (AS resins) and acrylonitrile-butadiene-styrene copolymers (ABS resins), polyolefin resins such as polyethylene (PE), polypropylene (PP) and ethylene-propylene copolymers, norbornene resins, and (meth)acrylic resins.

The plastic substrate may have a plate, film or other shape.

The plastic substrate used herein is not particularly limited and any of the above-mentioned plastic substrates may be advantageously used. The substrate may include a matrix of such material and a functional layer formed thereon. Exemplary of the functional layer are an antireflective layer and a hard coat layer.

The surface of the plastic substrate may be pretreated prior to formation of the silicon oxide underlayer. The pretreatment provides for tight adhesion between the plastic substrate and the silicon oxide underlayer, achieving high abrasion durability.

The method of pretreatment of the plastic substrate is not particularly limited as long as any contaminants can be removed from the plastic substrate surface and the plastic substrate surface be rendered hydrophilic. Exemplary of the pretreatment are wet cleaning such as detergent washing treatment with neutral detergents, typically kitchen detergents, alcohol washing treatment with alcohols such as ethanol and 2-propanol, and alkaline cleaning treatment with alkaline cleaning agents, and other cleaning treatments such as plasma cleaning treatment with oxygen or argon plasma, and radical cleaning treatment with OH radicals. These treatments may be used in combination. Inter alia, the neutral

detergent cleaning treatment and alkaline cleaning treatment are preferred, and the plasma cleaning treatment and radical cleaning treatment with OH radicals are more preferred. More preferably, the neutral detergent cleaning treatment or alkaline cleaning treatment is followed by the plasma cleaning treatment or radical cleaning treatment with OH radicals.

The effect of pretreatment of the plastic substrate is ascertained by the degree of hydrophilicity on the plastic substrate surface. Hydrophilicity can be evaluated in terms of a contact angle with water on the substrate. A contact angle of up to 40° is preferred, more preferably up to 20°, even more preferably up to 10°. The contact angle with water is measured according to JIS R 3257: 1999.

[Silicon oxide underlayer]

The silicon oxide underlayer is a silicon oxide film. The method of forming the silicon oxide film may be dry coating or wet coating. Suitable dry coating methods include physical vapor deposition (PVD) and chemical vapor deposition (CVD). Suitable wet coating methods include use of silica nano-particles, a sol-gel method using silicon alkoxide, and silica glass conversion by reaction of polysilazane with water.

The CVD method used herein may be thermal CVD, reactive species-assisted CVD, or photo-assisted CVD. From the standpoint of preventing the plastic substrate temperature from elevating, the reactive species-assisted CVD is preferably used.

The reactive species-assisted CVD method involves chemical reaction of a precursor with reactive species to convert the precursor to silicon oxide and depositing silicon oxide on a plastic substrate. As used herein, the reactive species include ions, electrons and radicals in an oxygen-containing plasma, and OH radicals created from ozone gas and an unsaturated hydrocarbon gas, e.g., ethylene gas. For example, the method of forming a silicon oxide film by the CVD method utilizing an oxygen-containing plasma is exemplified by the methods described in Patent Documents 9 and 10 (JP-A 2020-090652 and JP 5655215). The method of forming a silicon oxide film by the CVD method utilizing OH radicals is exemplified by the method described in Patent Document 14 (JP 6569831).

Silicon compounds are used as the precursor to silicon oxide. For example, $SiH_4$, $Si_2H_6$, tetraethoxysilane, hexamethyldisiloxane, and hexamethyldisilazane are useful. Inter alia, tetraethoxysilane, hexamethyldisiloxane, and hexamethyldisilazane are preferred.

CVD conditions during the formation of a silicon oxide film are set as appropriate in accordance with the type of plastic substrate and precursor. Since the film density of silicon oxide varies depending on the temperature of the plastic substrate, the plastic substrate temperature is preferably set from 30°C to lower than 150°C, more preferably from 30°C to 140°C when $SiH_4$ is used as the precursor, and preferably from 30°C to lower than 250°C, more preferably from 30°C to 150°C when tetraethoxysilane, hexamethyldisiloxane or hexamethyldisilazane is used as the precursor. Since this setting prevents silicon oxide from the closest packing during film formation, a film density as defined below is achieved.

The use of silica nano-particles belonging to the wet coating method is exemplified by the method described in Patent Document 13 (WO 2019/035271). By this method, a film density of approximately 2.0 g/cm$^3$ is achievable.

The sol-gel method using silicon alkoxide belonging to the wet coating method is exemplified by the method described in Patent Document 29 (JP-A 2007-011033).

The use of polysilazane belonging to the wet coating method is exemplified by a method involving applying perhydropolysilazane as the precursor by spraying, brush coating, spin coating or dip coating and allowing the precursor to stand in an ambient atmosphere to convert it to silicon oxide. This method is exemplified by the method described in Patent Document 10 (JP 5655215). During standing, the ambient temperature is preferably 15 to 30°C, the humidity (relative humidity) is preferably 30 to 95% RH, and the holding time is preferably about 12 to 36 hours.

The silicon oxide underlayer has a film density of 1.8 to 2.2 g/cm$^3$, preferably 1.80 to 2.20 g/cm$^3$, more preferably 1.84 to 2.15 g/cm$^3$. If the film density of the silicon oxide underlayer is less than 1.8 g/cm$^3$, which means that more voids are present in the silicon oxide underlayer, the adhesion between the silicon oxide underlayer and the water/oil repellent surface layer is improved due to the increased surface area, but the strength of the silicon oxide underlayer itself is lowered. If the film density exceeds 2.2 g/cm$^3$, the strength of the silicon oxide underlayer itself is kept, but the adhesion between the silicon oxide underlayer and the water/oil repellent surface layer is lowered. The film density of the silicon oxide underlayer can be measured by X-ray reflectometry (XRR). In the practice of the invention, the film density of the silicon oxide underlayer falls within the above-defined range as long as the silicon oxide film is formed by the aforementioned method under the aforementioned conditions.

The silicon oxide underlayer has a film thickness of 80 to 300 nm, preferably 80 to 220 nm. If the film thickness of the silicon oxide underlayer is less than 80 nm, the adhesion between the silicon oxide underlayer and the water/oil repellent surface layer is sometimes lost. If the film thickness exceeds 300 nm, the adhesion between the silicon oxide underlayer and the water/oil repellent surface layer may become poor due to shortage of the strength of the silicon oxide underlayer itself. The film thickness of the silicon oxide underlayer can be measured by X-ray reflectometry (XRR).

The silicon oxide underlayer preferably has an in-film hydrogen concentration of from 2 at% to 8 at%, more

preferably from 4 at% to 7 at%. The in-film hydrogen concentration of the silicon oxide underlayer can be measured by the Rutherford back-scattering method.

The surface of the silicon oxide underlayer may be treated prior to formation of the water/oil repellent surface layer. The pretreatment ensures to enhance the adhesion between the silicon oxide underlayer and the water/oil repellent surface layer, achieving high abrasion durability.

The method of pretreating the silicon oxide underlayer is not particularly limited as long as any contaminants can be removed from the surface of the silicon oxide underlayer. For example, plasma cleaning treatment with an oxygen plasma or argon plasma, and radical cleaning treatment with OH radicals are preferably used. When pretreatment is carried out, the plasma cleaning treatment is preferred.

[Water/oil repellent surface layer]

The water/oil repellent surface layer is composed mainly of a cured product of a fluoropolyether-containing polymer having a hydrolyzable silyl group and/or a partial hydrolytic condensate thereof. The water/oil repellent surface layer is formed on the silicon oxide underlayer using a surface treating agent containing a fluoropolyether-containing polymer having a hydrolyzable silyl group and/or a partial hydrolytic condensate thereof. As the fluoropolyether-containing polymer having a hydrolyzable silyl group, use may be made of the compounds described in Patent Documents 1 to 6 and 15 to 28 (JP 6260579, JP 6828744, JP 5761305, JP 6451279, JP 6741074, JP 6617853, JP-A 2011-116947, JP-A 2007-197425, JP-A 2007-297589, JP-A 2007-297543, JP-A 2008-088412, JP-A 2008-144144, JP-A 2010-031184, JP-A 2010-047516, JP-A 2011-178835, JP-A 2014-084405, JP-A 2014-105235, JP-A 2013-253228, JP-A 2014-218635, and WO 2013/121984).

The fluoropolyether-containing polymer having a hydrolyzable silyl group is described in further detail.

The fluoropolyether-containing polymer having a hydrolyzable silyl group has at least 2 groups, preferably 2 or 3 groups (or hydrolyzable silyl groups) represented by the formula (11):

[Chem. 11]

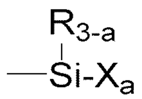 (11)

wherein R is a $C_1$-$C_4$ alkyl group or phenyl group, X is independently a hydrolyzable group, and a is 2 or 3, at one or more ends, preferably 1 to 3 ends of the molecule (i.e., at least 2, preferably 2 to 9, more preferably 2 to 6 hydrolyzable silyl groups per molecule) and preferably has a polyfluorooxyalkylene structure represented by $-(C_bF_{2b}O)_m-$ wherein b is an integer of 1 to 6 independently for each unit and m is an integer of 1 to 250, in the molecule.

In formula (11), X is each independently a hydrolyzable group. Examples of X include $C_1$-$C_{10}$ alkoxy groups such as methoxy, ethoxy, propoxy, isopropoxy, butoxy, isobutoxy, sec-butoxy, and tert-butoxy, $C_2$-$C_{10}$ alkoxy-substituted alkoxy groups such as methoxymethoxy, methoxyethoxy, ethoxymethoxy, and ethoxyethoxy, $C_2$-$C_{10}$ acyloxy groups such as acetoxy and propionoxy, $C_2$-$C_{10}$ alkenyloxy groups such as vinyloxy, allyloxy, propenoxy, and isopropenoxy, and halogen groups such as chloro, bromo and iodo. Inter alia, methoxy, ethoxy, isopropenoxy and chloro are preferred.

In formula (11), R is a $C_1$-$C_4$ alkyl group such as methyl, ethyl, propyl or butyl, or phenyl group, with methyl and ethyl being preferred.

In formula (11), "a" is 2 or 3, preferably 3 from the aspects of reactivity and adhesion to the substrate.

Examples of the group having formula (11) are shown below.

[Chem. 12]

$—Si(OCH_3)_3$

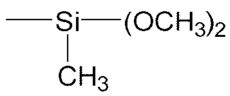

In the polyfluorooxyalkylene structure represented by $-(C_bF_{2b}O)_m-$, b is an integer of 1 to 6, preferably 1 to 4

independently for each unit, and m is an integer of 1 to 250, preferably 1 to 140.

Examples of the repeating unit represented by $-C_bF_{2b}O-$ include units of the following formulae:

$-CF_2O-$,

$-CF_2CF_2O-$,

$-CF_2CF_2CF_2O-$,

$-CF(CF_3)CF_2O-$,

$-CF_2CF_2CF_2CF_2O-$,

$-CF_2CF_2CF_2CF_2CF_2CF_2O-$, and

$-C(CF_3)_2O-$.

Of these, repeating units of the following formulae are especially preferred:

$-CF_2O-$

and

$-CF_2CF_2O-$.

The polyfluorooxyalkylene structure may be composed of repeating units of one type or repeating units of two or more types as illustrated above.

In the invention, the fluoropolyether-containing polymer having a hydrolyzable silyl group contains one or more fluoropolyether-containing polymers having the following formula (1), (4) or (7). More preferably, the fluoropolyether-containing polymer having a hydrolyzable silyl group consists of one or more fluoropolyether-containing polymers having the formula (1), (4) or (7).

[Chem. 13]

$A^1$-Rf-D (1)

Herein Rf is a divalent polyfluorooxyalkylene structure-containing group: $-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, p, q, r, s, t, and u are each independently an integer of 0 to 150, the sum of p, q, r, s, t, and u is an integer of 1 to 250, each unit may be straight or branched, the repeating units in parentheses with subscripts p, q, r, s, t, and u may be randomly arranged, $A^1$ is a monovalent fluorinated hydrocarbon group which is terminated with $CF_3-$ or $CF_2H-$ and may contain oxygen, or D, D is independently a monovalent group having the formula (2):

[Chem. 14]

$-Q-Z(W)_\alpha$ (2)

wherein Q is a single bond or a divalent organic group, Z is a tri- to octavalent group, $\alpha$ is an integer of 2 to 7, W is independently a monovalent hydrolyzable silyl-containing group having the formula (3):

[Chem. 15]

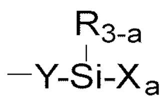

(3)

wherein R, X, and "a" are as defined above, Y is a single bond or a divalent hydrocarbon group which may contain at least one moiety selected from fluorine, silicon and siloxane bond.

[Chem. 16]

$A^2$-Rf-G (4)

Herein Rf is as defined above, $A^2$ is a monovalent fluorinated hydrocarbon group which is terminated with $CF_3$- or $CF_2H$- and may contain oxygen, or G, G is independently a monovalent group having the formula (5):

[Chem. 17]

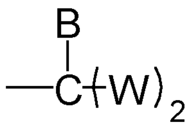

(5)

wherein W is as defined above, B is hydrogen or -OS, S is hydrogen, a $C_1$-$C_{10}$ monovalent hydrocarbon group, or a monovalent group having the formula (6):

[Chem. 18]

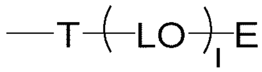

(6)

wherein T is a single bond or divalent group, L is independently a $C_1$-$C_4$ divalent hydrocarbon group, E is a $C_1$-$C_6$ monovalent hydrocarbon group or W, l is an integer of 0 to 20.
[Chem. 19]

$A^3$-Rf-J (7)

Herein Rf is as defined above, $A^3$ is a monovalent fluorinated hydrocarbon group which is terminated with $CF_3$- or $CF_2H$- and may contain oxygen, or J, J is independently a monovalent group having the formula (8):

[Chem. 20]

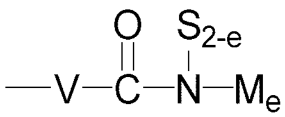

(8)

wherein S is as defined above, V is a single bond or a $C_2$-$C_{15}$ divalent hydrocarbon group which may contain an ether bond, M is independently a monovalent group having the formula (9):

[Chem. 21]

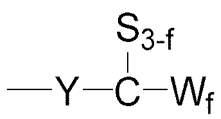

(9)

wherein Y, S, and W are as defined above, f is an integer of 1 to 3, and e is 1 or 2, J contains at least two W.
First, the fluoropolyether-containing polymer having the formula (1) is described.
[Chem. 22]

$A^1$-Rf-D (1)

In formula (1), Rf is a divalent polyfluorooxyalkylene (or perfluoropolyether) structure-containing group: $-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, preferably an integer of 0 to 2, more preferably 0 or 1, p, q, r, s, t, and u are each independently an integer of 0 to 150, preferably an integer of 0 to 100, more preferably an integer of 0 to 60, the sum of p, q, r, s, t, and u is an integer of 1 to 250, preferably an integer of 3 to 140, more preferably an integer of 7 to 70. Each unit may be straight or branched. The repeating units in parentheses with subscripts p, q, r, s, t, and u may be randomly arranged.

The divalent polyfluorooxyalkylene structure-containing group Rf is exemplified by the following structures.

[Chem. 23]

$-C_{d'}F_{2d'}-O-(C_2F_4O)_{q'}-C_{d'}F_{2d'}-$

$-C_{d'}F_{2d'}-O-(C_3F_6O)_{r'}-C_{d'}F_{2d'}-$

$-C_{d'}F_{2d'}-O-(CF_2O)_{p'}(C_2F_4O)_{q'}-C_{d'}F_{2d'}-$

$-C_{d'}F_{2d'}-O-(C_2F_4O)_{q'}(C_4F_8O)_{s'}-C_{d'}F_{2d'}-$

$-C_{d'}F_{2d'}-O-(CF_2O)_{p'}(C_2F_4O)_{q'}(C_3F_6O)_{r'}-C_{d'}F_{2d'}-$

$-C_{d'}F_{2d'}-O-(C_2F_4O)_{q'}(C_4F_8O)_{s'}(C_6F_{12}O)_{u'}-C_{d'}F_{2d'}-$

$-C_{d'}F_{2d}-O-(CF_2O)_{p'}(C_2F_4O)_{q'}(C_3F_6O)_{r'}(C_5F_{10}O)_{t'}-C_{d'}F_{2d'}-$

$-C_{d'}F_{2d'}-O-(CF_2O)_{p'}(C_2F_4O)_{q'}(C_3F_6O)_{r'}(C_4F_8O)_{s'}(C_5F_{10}O)_{t'}(C_6F_{12}O)_{u'}-C_{d'}F_{2d'}-$

Herein p', q', r', s', t', and u' are each independently an integer of 1 to 150, the sum of p', q', r', s', t', and u' is an integer of 12 to 250. Each unit may be straight or branched. The repeating units in parentheses with subscripts p', q', r', s', t', and u' may be randomly arranged. The subscript d' is an integer of 0 to 5 independently for each unit, and the unit with d' may be straight or branched.

In formula (1): $A^1$-Rf-D, $A^1$ is a monovalent fluorinated hydrocarbon group which is terminated with $CF_3$- or $CF_2H$- and may contain oxygen, or D which is a monovalent group having the formula (2): $-Q-Z(W)_\alpha$. The monovalent fluorinated hydrocarbon group which is terminated with $CF_3$- or $CF_2H$- and may contain oxygen is preferably a $C_1$-$C_6$ fluoroalkyl group, more preferably a group giving a polymer terminated with $CF_3$- or $CF_2H$-.

Examples of the monovalent fluorinated hydrocarbon group which is terminated with $CF_3$- or $CF_2H$- and may contain oxygen, represented by $A^1$, include the following groups.

[Chem. 24] $CF_2H$- $CF_3$- $C_2F_5$- $C_3F_7$- $C_4F_9$- $C_3F_7OCFHCF_2OCH_2$- $CF_3OCFHCF_2OCH_2$- $CF_3OC_3F_6OCFHCF_2OCH_2$-

In formula (1): $A^1$-Rf-D, D is independently a monovalent group having the formula (2).

[Chem. 25]

$$-Q-Z(W)_\alpha \qquad (2)$$

In formula (2), Q is a single bond or a divalent organic group. Besides a single bond, Q is desirably an unsubstituted or substituted divalent hydrocarbon group of 1 to 15 carbon atoms, preferably 2 to 15 carbon atoms, which may contain at least one bond selected from the group consisting of an amide bond (e.g., unsubstituted amide bond, N-methyl-substituted amide bond, or N-phenyl-substituted amide bond), ether bond, ester bond, sulfide bond, urethane bond, siloxane bond, triazine bond, diorganosilylene moiety (e.g., dialkylsilylene moiety such as dimethylsilylene), silarylene bond (e.g., silphenylene bond), and silalkylene bond (e.g., silethylene bond), more desirably an unsubstituted or fluorine-substituted divalent hydrocarbon group of 1 to 12 carbon atoms, preferably 2 to 12 carbon atoms, which may contain the aforementioned bond.

Examples of the silalkylene bond and silarylene bond are shown below.

[Chem. 26]

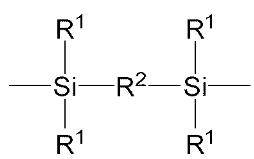

Herein, $R^1$ which may be the same or different is a $C_1$-$C_8$, preferably $C_1$-$C_4$ alkyl group such as methyl, ethyl, propyl or butyl, or a $C_6$-$C_{10}$ aryl group such as phenyl. $R^2$ is a $C_1$-$C_4$ alkylene group such as methylene, ethylene or propylene (trimethylene or methylethylene), or a $C_6$-$C_{10}$ arylene group such as phenylene.

Examples of the group Q other than a single bond are shown below. In the following structures, preferably the

valence bond on the left is attached to Rf and the valence bond on the right is attached to Z.

[Chem. 27]

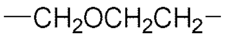
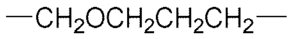
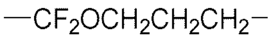
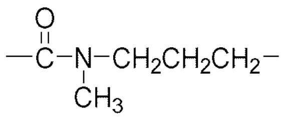
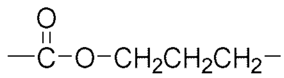
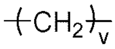
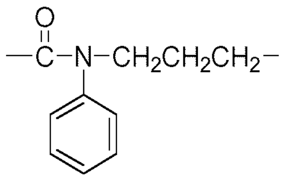
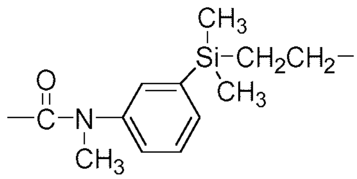
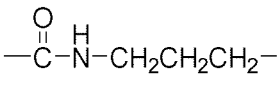

Herein v is an integer of 2 to 4.

In formula (2): -Q-Z(W)$_\alpha$, Z is a tri- to octavalent group, preferably silicon, nitrogen or a tri- to octavalent organopolysiloxane residue having a siloxane bond, more preferably a tri- to octavalent, most preferably tri- or tetravalent group selected from straight, branched or cyclic organopolysiloxane residues of 3 to 13 silicon atoms, preferably 3 to 5 silicon atoms. Z may contain a silalkylene structure (typically silethylene structure) in which two silicon atoms are linked by an alkylene group such as ethylene, i.e., Si-$(CH_2)_n$-Si wherein n is an integer of 2 to 6, preferably 2 to 4.

Also, the tri- to octavalent organopolysiloxane residue having a siloxane bond is exemplified by the following groups.

[Chem. 28]

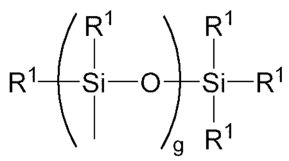
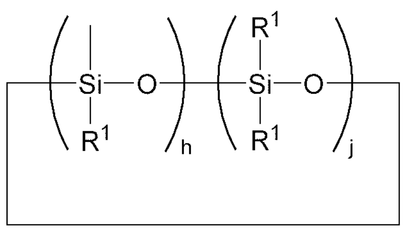
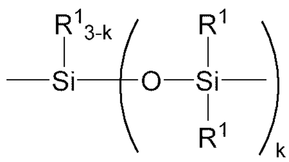

Herein $R^1$ is as defined above, g is an integer of 3 to 12, preferably 3 or 4, h is an integer of 3 to 8, preferably 3 or 4, j is an integer of 0 to 8, preferably 0 or 1, h+j is an integer of 3 to 13, preferably 3 to 5, and k is 2 or 3.

[Chem. 29]

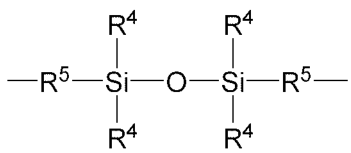

Herein $R^4$ is independently $R^1$ or a group having the following formula (a):

[Chem. 30]

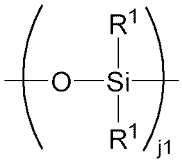

(a)

wherein $R^1$ is as defined above, j 1 is an integer of 1 to 6, preferably 1, the valence bond on the left side is attached to Si, and $R^5$ is independently a single bond or a group having the following formula (b):

[Chem. 31]

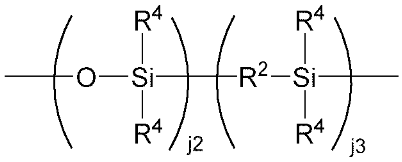

(b)

wherein $R^2$ and $R^4$ are as defined above, j2 is an integer of 0 to 6, preferably 0 to 3, j3 is an integer of 0 to 6, preferably 0 to 2, the repeating units within parentheses may be randomly arranged, the valence bond on the left side is attached to Si, and at least one $R^4$ is a group having formula (a).

Exemplary structures of Z are shown below.

[Chem. 32]

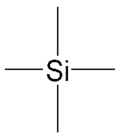

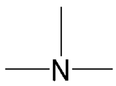

[Chem. 33]

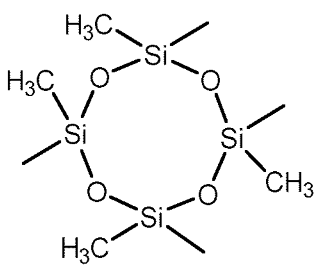

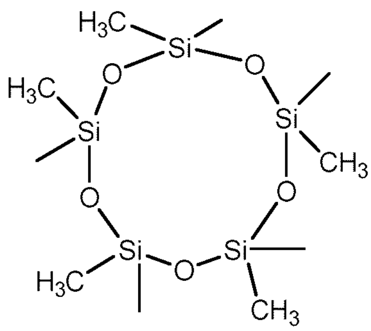

[Chem. 34]

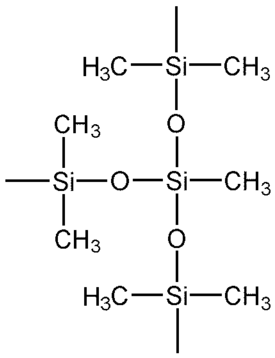

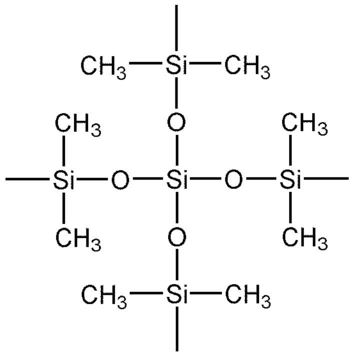

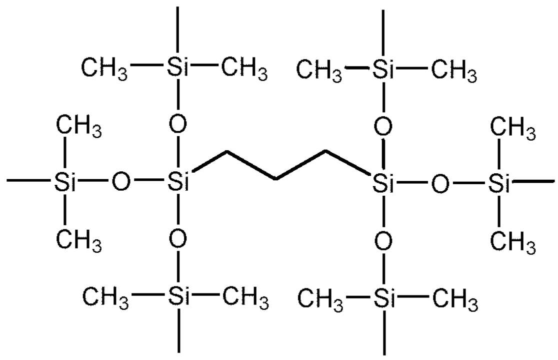

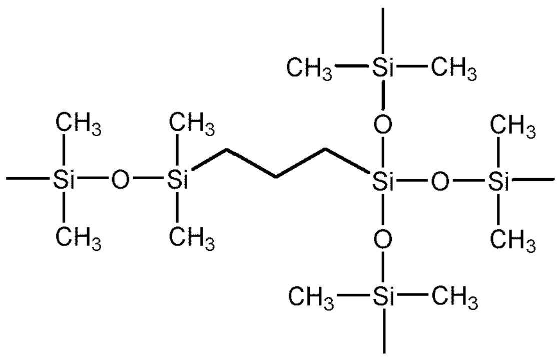

[Chem. 35]

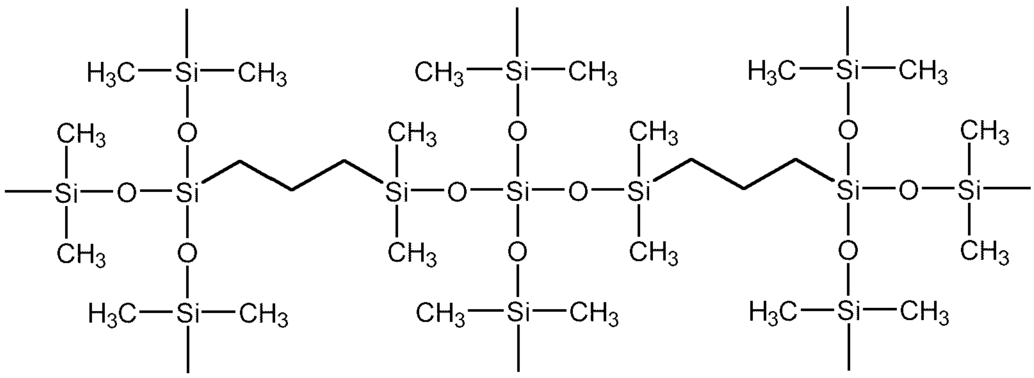

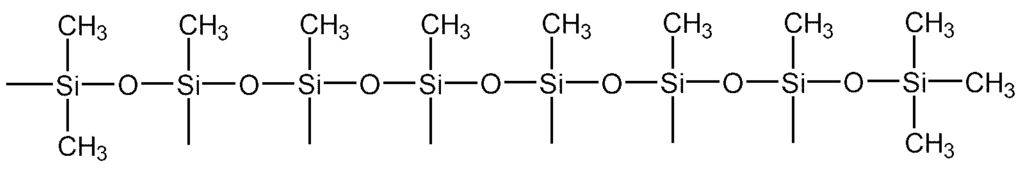

In formula (2): -Q-Z(W)$_\alpha$, W is independently a monovalent hydrolyzable silyl-containing group having the formula (3):

[Chem. 36]

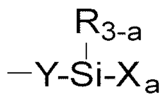
(3)

wherein R, X and "a" are as defined above, Y is a single bond or a divalent hydrocarbon group which may contain at least one moiety selected from fluorine, silicon and siloxane bond.

In formula (3), R, X and "a" are as defined for R, X and "a" in formula (11) and as exemplified for R, X and "a" in formula (11).

In formula (3), Y is a single bond or a divalent hydrocarbon group of preferably 1 to 20 carbon atoms which may contain at least one moiety selected from fluorine, silicon and siloxane bond. Examples of the divalent hydrocarbon group which may contain at least one moiety selected from fluorine, silicon and siloxane bond include $C_1$-$C_l$o alkylene groups, $C_1$-$C_l$o alkylene groups containing fluorine, alkylene groups containing $C_6$-Cs arylene moiety (i.e., alkylene-arylene groups), divalent groups having alkylene groups linked via a silalkylene structure or silarylene structure, and divalent groups in which $C_2$-$C_{10}$ alkylene groups are attached to the valence bonds of a divalent straight organopolysiloxane residue of 2 to 10 silicon atoms or a divalent branched or cyclic organopolysiloxane residue of 3 to 10 silicon atoms.

Examples of the group Y other than a single bond are shown below.

[Chem. 37]

$-CH_2-$

$-CH_2CH_2-$ $-CF_2CHF-$

$-CH_2CH_2CH_2-$ $-CF_2CF_2CHF-$

$-CH_2CH_2CH_2CH_2CH_2CH_2-$

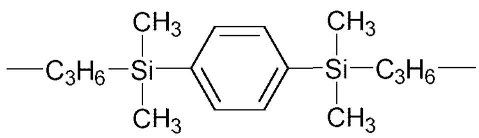

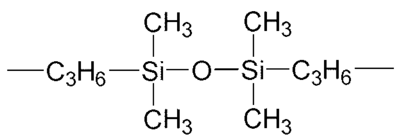

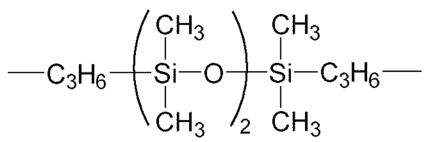

Examples of the group having formula (3) are shown below.

[Chem. 38]

$-Si(OCH_3)_3$

$-CH_2CH_2-Si(OCH_3)_3$

$-CF_2CHF-Si(OCH_3)_3$

$-CH_2CH_2CH_2-Si(OCH_3)_3$

$-CF_2CF_2CHF-Si(OCH_3)_3$

$-(CH_2)_6-Si(OCH_3)_3$

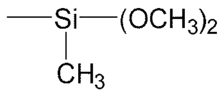

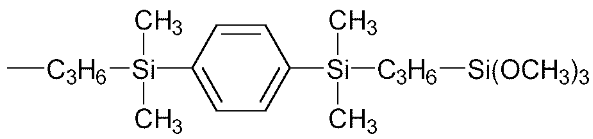

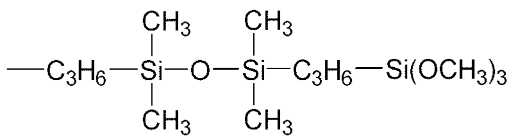

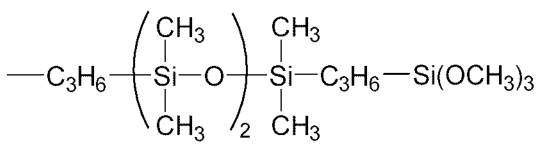

In formula (2): -Q-Z(W)$_\alpha$, $\alpha$ indicative of the number of W is an integer of 2 to 7.

Examples of the group having formula (2): -Q-Z(W)$_\alpha$, that is D in formula (1), are shown below.

[Chem. 39]

$-CH_2CH_2-N(C_3H_6Si(OCH_3)_3)_2$

$-CH_2CH_2-Si(C_3H_6Si(OCH_3)_3)_3$

$-CH_2OCH_2CH_2CH_2-Si(C_3H_6Si(OCH_3)_3)_3$

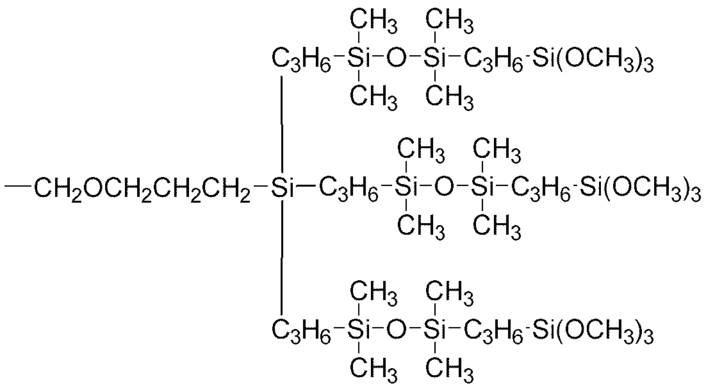

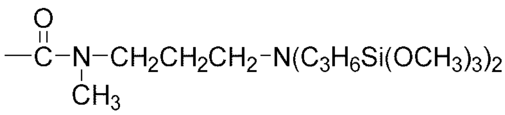

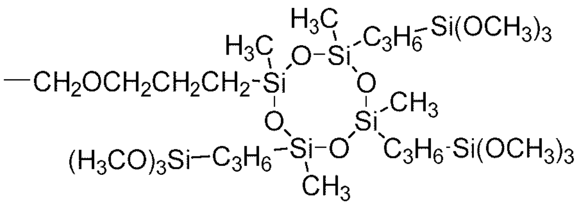

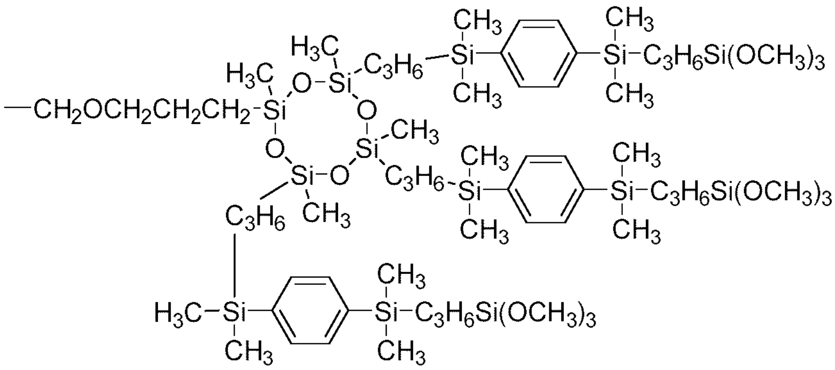

Examples of the fluoropolyether-containing polymer having formula (1) are shown below.

[Chem. 40]

$A^1\text{-}Rf-CH_2CH_2-N(C_3H_6Si(OCH_3)_3)_2$

$A^1\text{-}Rf-CH_2CH_2-Si(C_3H_6Si(OCH_3)_3)_3$

$A^1\text{-}Rf-CH_2OCH_2CH_2CH_2-Si(C_3H_6Si(OCH_3)_3)_3$

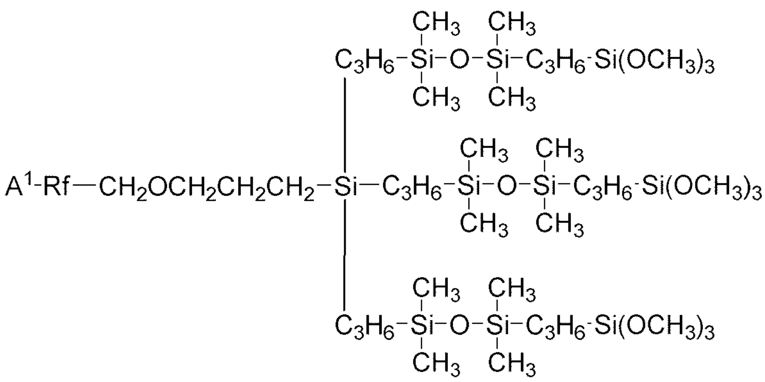

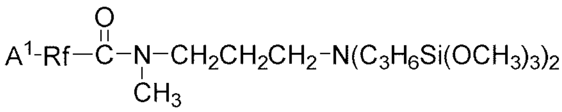

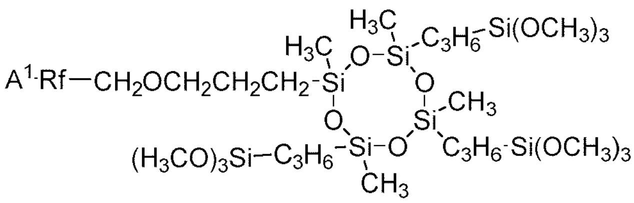

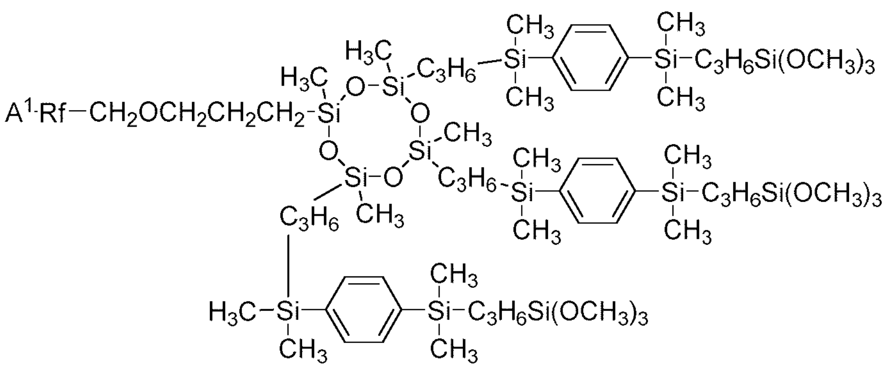

Herein $A^1$ and Rf are as defined above.

Next, the fluoropolyether-containing polymer having the formula (4) is described.

[Chem. 41]

$$A^2\text{-Rf-G} \qquad (4)$$

In formula (4), Rf is as defined above and as exemplified above for Rf in formula (1).

In formula (4): $A^2$-Rf-G, $A^2$ is a monovalent fluorinated hydrocarbon group which is terminated with $CF_3$- or

$CF_2H$- and may contain oxygen, or G which is a monovalent group having the formula (5): -C(B)$(W)_2$. The monovalent fluorinated hydrocarbon group which is terminated with $CF_3$- or $CF_2H$- and may contain oxygen is preferably a $C_1$-$C_6$ fluoroalkyl group, more preferably a group giving a polymer terminated with $CF_3$- or $CF_2H$-.

Examples of the monovalent fluorinated hydrocarbon group which is terminated with $CF_3$- or $CF_2H$- and may contain oxygen, represented by $A^2$, include the following groups.

[Chem. 42] $CF_2H$- $CF_3$- $C_2F_5$- $C_3F_7$- $C_4F_9$- $C_3F_7OCFHCF_2OCH_2$- $CF_3OCFHCF_2OCH_2$- $CF_3OC_3F_6OCFHCF_2OCH_2$-

In formula (4): $A^2$-Rf-G, G is independently a monovalent group having the formula (5).

[Chem. 43]

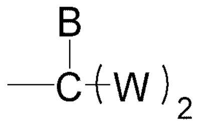

(5)

In formula (5), W is as defined above and as exemplified above for W in formula (2).

In formula (5): -C(B)$(W)_2$, B is hydrogen or -OS. S is hydrogen, a $C_1$-$C_{10}$ monovalent hydrocarbon group, or a monovalent group having the following formula (6).

[Chem. 44]

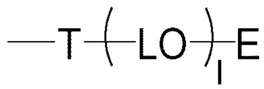

(6)

Examples of the $C_1$-$C_l$o monovalent hydrocarbon group represented by S include alkyl groups such as methyl, ethyl, propyl, butyl, pentyl, hexyl and octyl, alkenyl groups such as vinyl and allyl, aryl groups such as phenyl and tolyl, and aralkyl groups such as benzyl and phenylethyl. Inter alia, $C_1$-$C_3$ alkyl groups and phenyl are preferred.

In formula (6): -T-$(LO)_1$-E, T is a single bond or divalent group, preferably a single bond or a $C_2$-$C_{20}$ divalent hydrocarbon group which may contain at least one bond selected from the group consisting of silicon, siloxane bond, silalkylene bond (e.g., silethylene bond or silpropylene bond), silarylene bond (e.g., silphenylene bond), and diorganosilylene moiety (e.g., dialkylsilylene moiety such as dimethylsilylene or dialkoxysilylene moiety such as dimethoxysilylene), a divalent siloxane bond, silalkylene group or diorganosilylene group. Examples of the group T other than a single bond are shown below. It is noted that the valence bond on the right side in the following structure is preferably attached to L or E.

[Chem. 45]

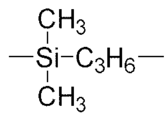

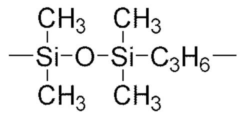

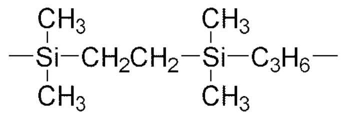

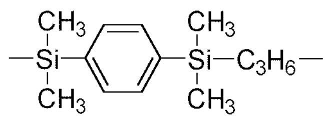

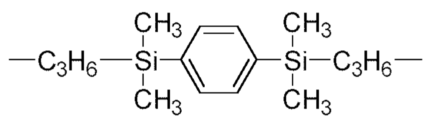

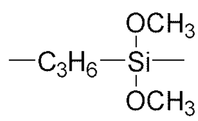

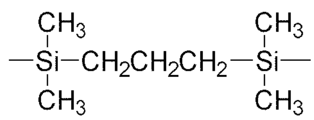

In formula (6): $-T-(LO)_1-E$, L is independently a $C_1$-$C_4$ divalent hydrocarbon group, typically alkylene group such as methylene, ethylene, propylene (trimethylene or methylethylene) or butylene (tetramethylene). For (LO) units, the number of carbon atoms may be identical or different.

In formula (6): $-T-(LO)_1-E$, l is an integer of 0 to 20, preferably an integer of 0 to 10, more preferably 0 to 6. It is noted that when (LO) is contained, l is preferably at least 1, more preferably at least 2.

In formula (6): $-T-(LO)_1-E$, E is a $C_1$-$C_6$ monovalent hydrocarbon group such as a $C_1$-$C_4$ alkyl group, e.g., methyl, ethyl, propyl or butyl or phenyl, or W. W is as defined above and as exemplified above for W in formula (2).

Examples of the monovalent group having formula (6): -T-(LO)i-E are shown below.

[Chem. 46]

$-(CH_2CH_2O)_2-CH_3$

$-(CH_2CH_2O)_3-CH_3$

$-(CH_2CH_2O)_4-CH_3$

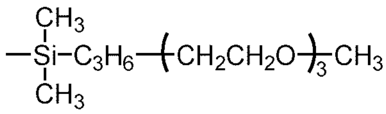

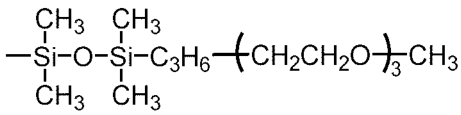

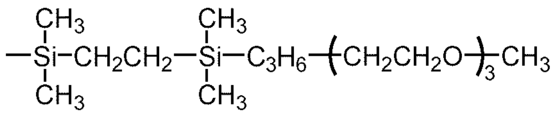

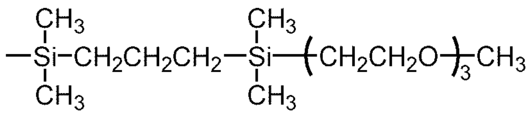

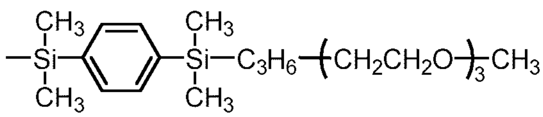

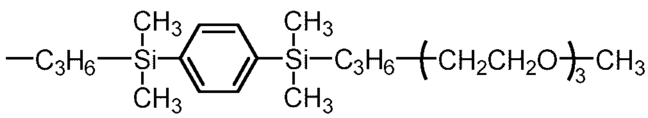

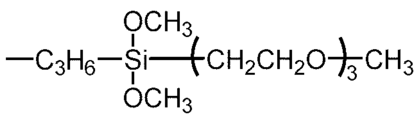

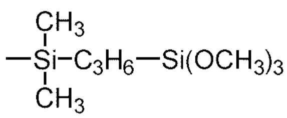

$-C_3H_6-Si(OCH_3)_3$

Examples of the monovalent group having formula (5): $-C(B)(W)_2$, represented by G in formula (4), are shown below.

[Chem. 47]

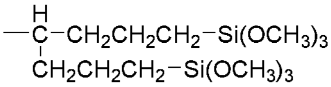

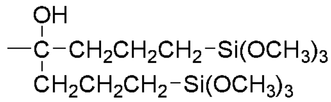

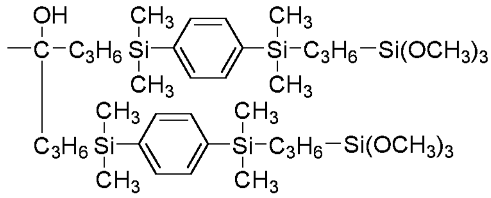

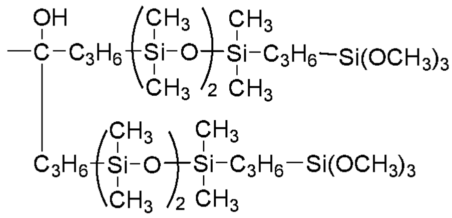

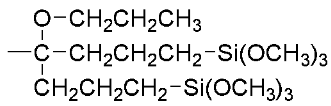

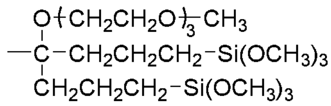

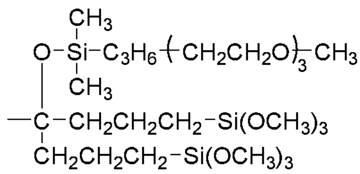

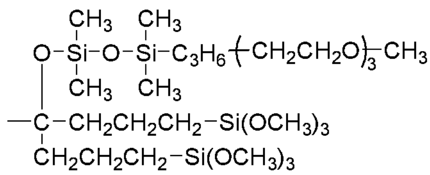

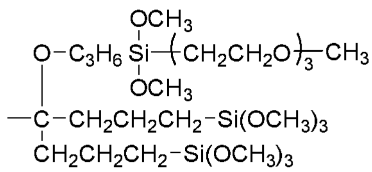

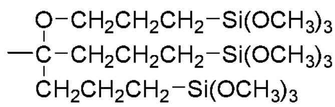

Examples of the fluoropolyether-containing polymer having formula (4) are shown below.

[Chem. 48]

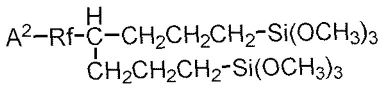

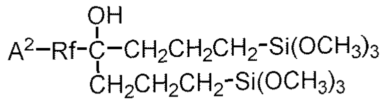

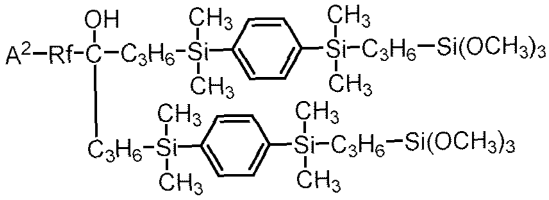

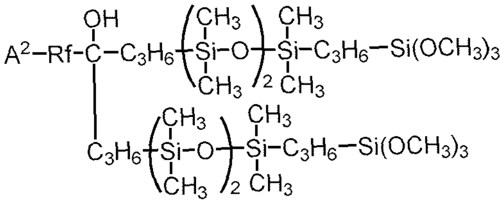

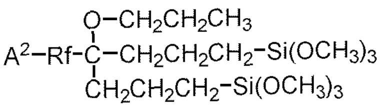

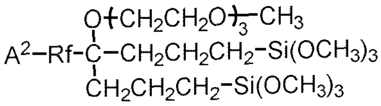

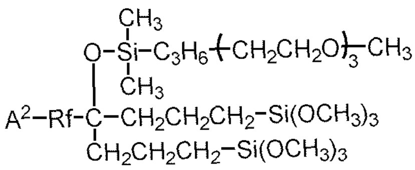

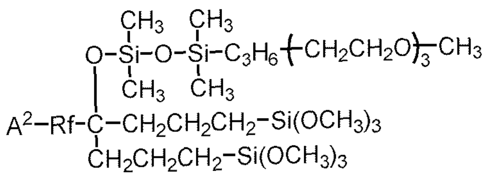

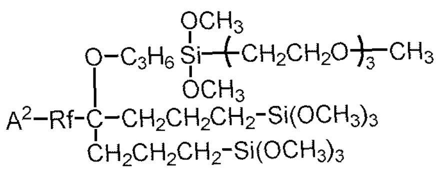

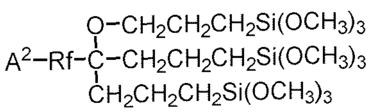

Herein $A^2$ and Rf are as defined above.

Next, the fluoropolyether-containing polymer having the formula (7) is described.

[Chem. 49]

$$A^3\text{-Rf-J} \qquad (7)$$

In formula (7), Rf is as defined above and as exemplified above for Rf in formula (1).

In formula (7): $A^3$-Rf-J, $A^3$ is a monovalent fluorinated hydrocarbon group which is terminated with $CF_3$- or

$CF_2H$- and may contain oxygen, or J, which is a monovalent group having the formula (8): -V-C(=O)N(S)$_{2-e}$(M)$_e$. The monovalent fluorinated hydrocarbon group which is terminated with $CF_3$- or $CF_2H$- and may contain oxygen is preferably a $C_1$-$C_6$ fluoroalkyl group, more preferably a group giving a polymer terminated with $CF_3$- or $CF_2H$-.

Examples of the monovalent fluorinated hydrocarbon group which is terminated with $CF_3$- or $CF_2H$- and may contain oxygen, represented by $A^3$, are shown below.

[Chem. 50] $CF_2H$- $CF_3$- $C_2F_5$- $C_3F_7$- $C_4F_9$- $C_3F_7OCFHCF_2OCH_2$- $CF_3OCFHCF_2OCH_2$- $CF_3OC_3F_6OCFHCF_2OCH_2$-

In formula (7): $A^3$-Rf-J, J is independently a group having the formula (8), J containing at least 2 W.

[Chem. 51]

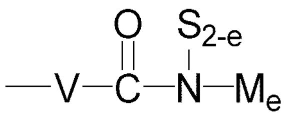

(8)

In formula (8), S is as defined above and as exemplified above for S.

In formula (8), V is a single bond or a $C_2$-$C_{15}$ divalent hydrocarbon group which may contain an ether bond. Examples of the group V other than a single bond are shown below. It is noted that the valence bond on the right side in the following structure is preferably attached to the carbon atom (-C(=O)-).

[Chem. 52] $-CH_2OCH_2-$ $-CH_2OCH_2CH_2CH_2CH_2-$ $-CH_2CH_2CH_2OCH_2CH_2CH_2-$

In formula (8), e is 1 or 2, preferably 1.

In formula (8), M is independently a monovalent group having the formula (9).

[Chem. 53]

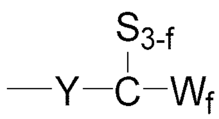

(9)

In formula (9), Y, S, and W are as defined above and as exemplified above for Y in formula (3), S and W in formula (2).

In formula (9), f is an integer of 1 to 3.

Examples of the monovalent group having formula (9): -Y-C(S)$_{3-f}$(W)$_f$, represented by M in formula (8), are shown below.

[Chem. 54]

$—C_3H_6—Si(OCH_3)_3$

$—C_7H_{14}\text{-}Si(OCH_3)_3$

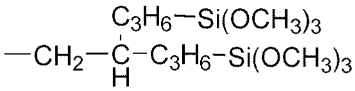

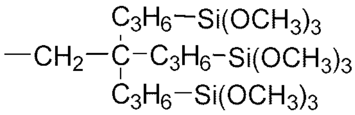

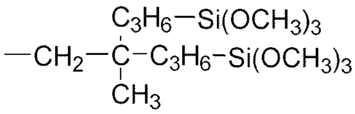

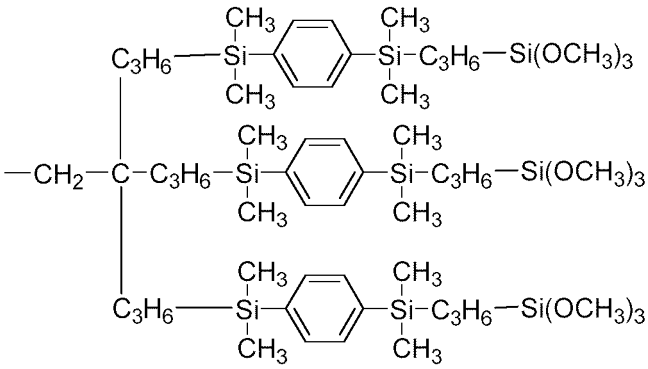

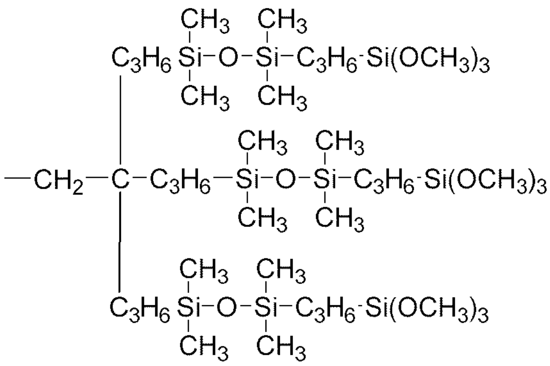

Examples of the monovalent group having formula (8): $-V-C(=O)N(S)_{2-e}(M)_e$ are shown below.

[Chem. 55]

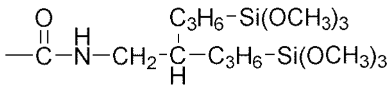

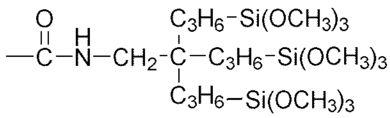

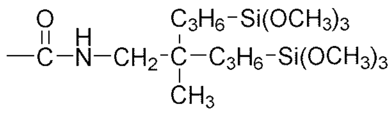

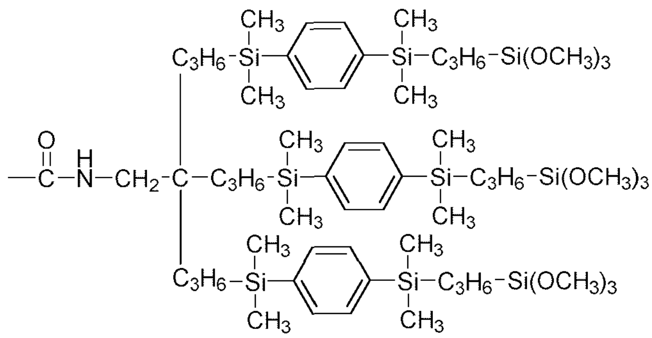

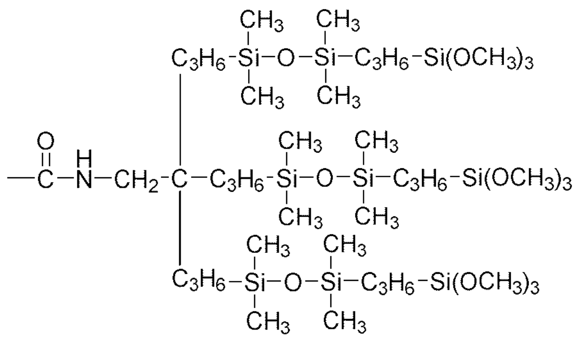

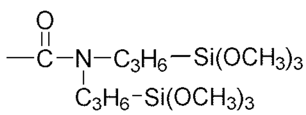

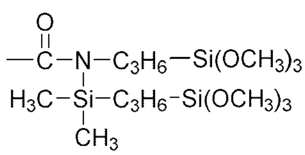

[Chem. 56]

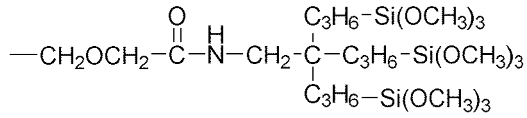

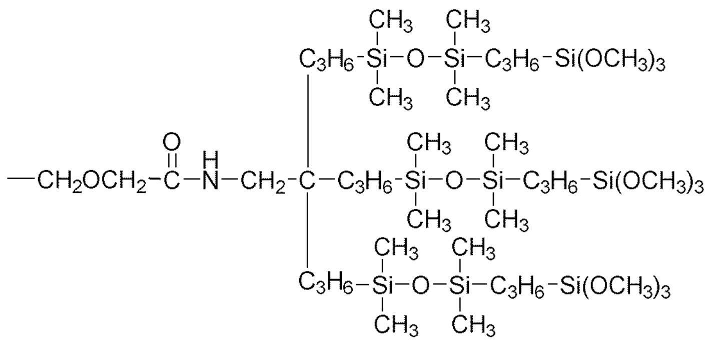

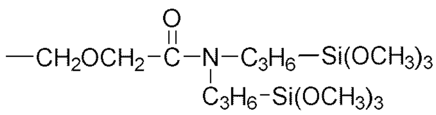

Examples of the fluoropolyether-containing polymer having formula (7) are shown below.

[Chem. 57]

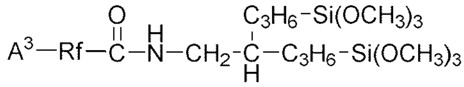

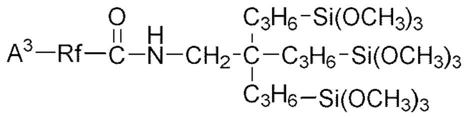

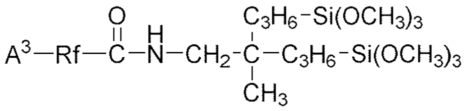

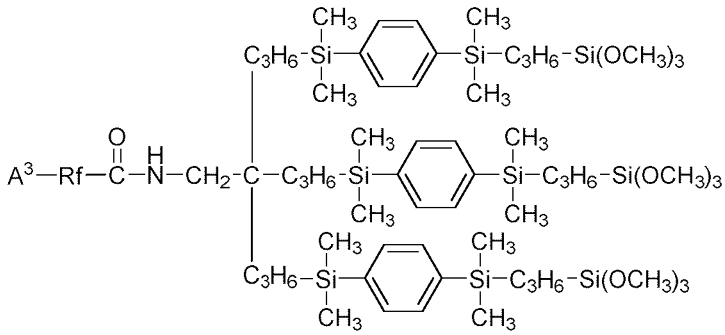

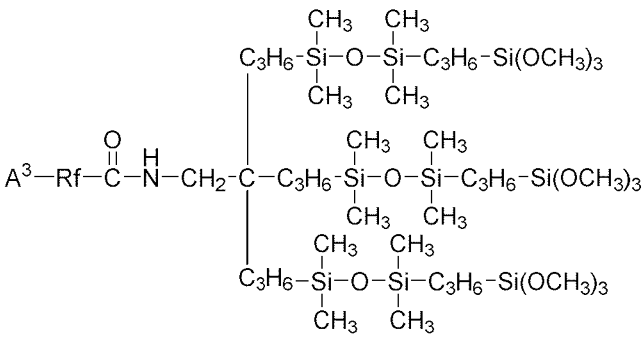

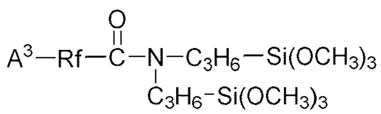

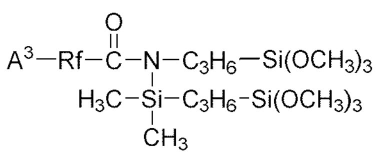

[Chem. 58]

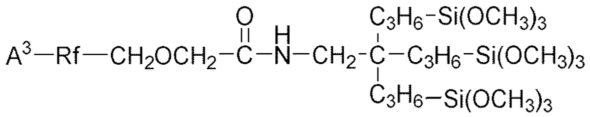

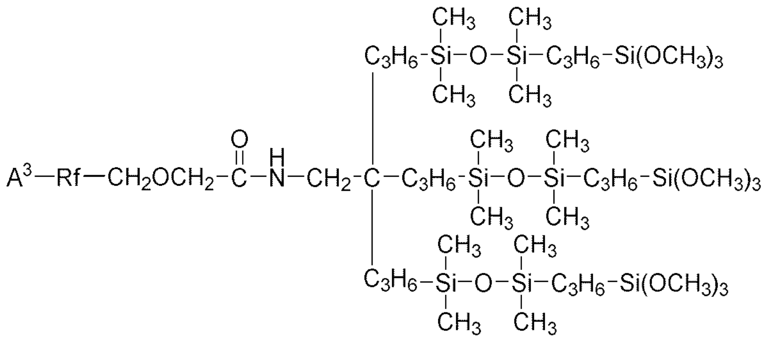

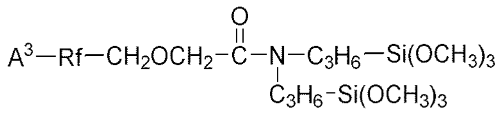

Herein $A^3$ and Rf are as defined above.

The surface treating agent for forming the water/oil repellent surface layer in the inventive article comprises a fluoropolyether-containing polymer having a hydrolyzable silyl group and/or a partial hydrolytic condensate thereof. The surface treating agent may be a mixture (i.e., fluoropolyether-containing polymer composition) comprising the fluoropolyether-containing polymer having a hydrolyzable silyl group and/or the partial hydrolytic condensate thereof and a fluoropolyether-containing polymer having the formula (10), free of a hydrolyzable silyl group, which is referred to as hydrolyzable silyl group-free polymer, and/or a partial (hydrolytic) condensate thereof. As used herein, the term "partial (hydrolytic) condensate" refers to a partial condensate or partial hydrolytic condensate.

[Chem. 59]

$$A^4\text{-}Rf\text{-}A^4 \qquad (10)$$

Herein Rf is as defined above and as exemplified above for Rf in formula (1). $A^4$ is independently a monovalent fluorinated hydrocarbon group which is terminated with $CF_3$- or $CF_2H$- and may contain oxygen, or $-OR^3$, $-COOR^3$ or $-PO(OR^3)_2$ wherein $R^3$ is hydrogen or a $C_1$-$C_{10}$ monovalent hydrocarbon group.

In formula (10), $A^4$ is independently a monovalent fluorinated hydrocarbon group which is terminated with $CF_3$- or $CF_2H$- and may contain oxygen, or $-OR^3$, $-COOR^3$ or $-PO(OR^3)_2$. Examples of the monovalent fluorinated hydrocarbon group which is terminated with $CF_3$- or $CF_2H$- and may contain oxygen are as exemplified above for the monovalent fluorinated hydrocarbon group which is terminated with $CF_3$- or $CF_2H$- and may contain oxygen, represented by $A^1$.

Herein, $R^3$ is hydrogen or a $C_1$-$C_{10}$ monovalent hydrocarbon group. Examples of the monovalent hydrocarbon group include alkyl groups such as methyl, ethyl, propyl, butyl, pentyl, hexyl and octyl, alkenyl groups such as vinyl and allyl, aryl groups such as phenyl and tolyl, and aralkyl groups such as benzyl and phenylethyl. $R^3$ is preferably hydrogen, $C_1$-$C_3$ alkyl group or phenyl group.

Examples of $-OR^3$, $-COOR^3$ and $-PO(OR^3)_2$, represented by $A^4$, include -OH, $-OCH_3$, -COOH, $-COOCH_3$, $-PO(OH)_2$, $-OC_2H_5$, and $-COOC_2H_5$.

Examples of the fluoropolyether-containing polymer having formula (10) are shown below.

[Chem. 60]

$CF_3\text{-}O\text{-}(CF_2O)_{p'''}(C_2F_4O)_{q'''}(C_3F_6O)_{r'''}(C_4F_8O)_{s'''}(C_5F_{10}O)_{t'''}(C_6F_{12}O)_{u'''}\text{-}CF_3$

$CF_3\text{-}O\text{-}(CF_2O)_{p'''}(C_2F_4O)_{q'''}(C_3F_6O)_{r'''}(C_4F_8O)_{s'''}(C_5F_{10}O)_{t'''}(C_6F_{12}O)_{u'''}\text{-}CF_2\text{-}COOH$

$CF_3\text{-}O\text{-}(CF_2O)_{p'''}(C_2F_4O)_{q'''}(C_3F_6O)_{r'''}(C_4F_8O)_{s'''}(C_5F_{10}O)_{t'''}(C_6F_{12}O)_{u'''}\text{-}CF_2\text{-}COOCH_3$

$CF_3\text{-}O\text{-}(CF_2O)_{p'''}(C_2F_4O)_{q'''}(C_3F_6O)_{r'''}(C_4F_8O)_{s'''}(C_5F_{10}O)_{t'''}(C_6F_{12}O)_{u'''}\text{-}CF_2\text{-}PO(OH)_2$

$CF_3\text{-}O\text{-}(CF_2O)_{p''}(C_2F_4O)_{q''}(C_3F_6O)_{r''}(C_4F_8O)_{s''}(C_sF_{10}O)_{t''}(C_6F_{12}O)_{u''}\text{-}CF_2\text{-}OH$

$CF_3\text{-}O\text{-}(CF_2O)_{p''}(C_2F_4O)_{q''}(C_3F_6O)_{r''}(C_4F_8O)_{s''}(C_5F_{10}O)_{t''}(C_6F_{12}O)_{u''}\text{-}CF_2\text{-}OCH_3$

$HOOC\text{-}CF_2\text{-}O\text{-}(CF_2O)_{p''}(C_2F_4O)_{q''}(C_3F_6O)_{r''}(C_4F_8O)_{s''}(C_5F_{10}O)_{t''}(C_6F_{12}O)_{u''}\text{-}CF_2\text{-}COOH$

$HO\text{-}CF_2\text{-}O\text{-}(CF_2O)_{p''}(C_2F_4O)_{q''}(C_3F_6O)_{r''}(C_4F_8O)_{s''}(C_5F_{10}O)_{t''}(C_6F_{12}O)_{u''}\text{-}CF_2\text{-}OH$

Herein, p", q", r", s", t", and u" are each independently an integer of 0 to 150, the sum of p", q", r", s", t", and u" is 12 to 250, each unit may be straight or branched, the repeating units in parentheses with subscripts p", q", r", s", t", and u" may be randomly arranged.

The surface treating agent for forming the water/oil repellent surface layer in the inventive article comprises at least one of fluoropolyether-containing polymers each having at least 2 hydrolyzable silyl groups at one end of the molecular chain, represented by the above formulae (1), (4) and (7) and/or partial hydrolytic condensates thereof (single end type polymer), or at least one of fluoropolyether-containing polymers each having at least 2 hydrolyzable silyl groups at both ends of the molecular chain, represented by the above formulae (1), (4) and (7) and/or partial hydrolytic condensates thereof (dual end type polymer), a mixture containing at least one single end type polymer and at least one dual end type polymer, or a mixture (i.e., fluoropolyether-containing polymer composition) containing any one of the foregoing and a hydrolyzable silyl group-free polymer.

In the surface treating agent comprising the fluoropolyether-containing polymer mixture (fluoropolyether-containing polymer composition), although the mixing ratio of the single end type polymer and/or dual end type polymer to the hydrolyzable silyl group-free polymer is not particularly limited, the hydrolyzable silyl group-free polymer is desirably 0.01 to 30 mol%, more desirably 0.1 to 10 mol% of the overall fluoropolyether-containing polymer composition consisting of the single end type polymer and/or dual end type polymer and the hydrolyzable silyl group-free polymer.

In the surface treating agent, the fluoropolyether-containing polymer having a hydrolyzable silyl group and/or partial hydrolytic condensate thereof, or the fluoropolyether-containing polymer composition preferably has a number average molecular weight (Mn) of 1,000 to 20,000. The Mn is more preferably 2,000 to 10,000, even more preferably 3,000 to 8,000. Notably, the number average molecular weight can be computed from a ratio of characteristic peak strengths in $^{19}$F-NMR spectroscopy.

The fluoropolyether-containing polymer having a hydrolyzable silyl group and/or partial hydrolytic condensate thereof, or the fluoropolyether-containing polymer composition, having a Mn in the above-defined range, is obtainable by rectification or molecular distillation of the fluoropolyether-containing polymer having a hydrolyzable silyl group and/or partial hydrolytic condensate thereof, or the fluoropolyether-containing polymer composition.

The fluoropolyether-containing polymer having a hydrolyzable silyl group and/or partial hydrolytic condensate thereof, or the fluoropolyether-containing polymer composition, having a Mn in the above-defined range, is also obtainable by previously modifying the fluorine compound used in the synthesis of the fluoropolyether-containing polymer so as to have a Mn in the above-defined range.

To the surface treating agent, hydrolytic condensation catalysts may be added, if necessary, for example, organotin compounds (e.g., dibutyltin dimethoxide and dibutyltin dilaurate), and organotitanium compounds (e.g., tetra-n-butyl titanate), organic acids (e.g., acetic acid, methanesulfonic acid and fluorine-modified carboxylic acid), and inorganic acids (e.g., hydrochloric acid and sulfuric acid). Of these, acetic acid, tetra-n-butyl titanate, dibutyltin dilaurate, and fluorine-modified carboxylic acid are desirable. The addition amount is a catalytic amount and typically 0.01 to 5 parts by weight, especially 0.1 to 1 part by weight per 100 parts by weight of the fluoropolyether-containing polymer having a hydrolyzable silyl group and/or partial hydrolytic condensate thereof.

The surface treating agent may also contain a solvent. The solvent may be preferably selected from fluorine-modified aliphatic hydrocarbon-based solvents (e.g., perfluoroheptane and perfluorooctane), fluorine-modified olefin-based solvents (e.g., methoxyperfluoroheptene), fluorine-modified aromatic hydrocarbon-based solvents (e.g., m-xylene hexafluoride, benzotrifluoride, and 1,3-trifluoromethylbenzene), fluorine-modified ether-based solvents (e.g., methyl perfluorobutyl ether, ethyl perfluorobutyl ether, and perfluoro(2-butyltetrahydrofuran)), fluorine-modified alkyl amine-based solvents (e.g., perfluorotributylamine and perfluorotripentylamine), hydrocarbon-based solvents (e.g., petroleum benzine, mineral spirits, toluene and xylene), and ketone-based solvents (e.g., acetone, methyl ethyl ketone and methyl isobutyl ketone). Inter alia, fluorine-modified solvents, also referred to as fluorinated solvents, are desirable in view of solubility and wettability. Especially, 1,3-trifluoromethylbenzene, m-xylene hexafluoride, perfluoro(2-butyltetrahydrofuran), perfluorotributylamine, and ethyl perfluorobutyl ether are preferred.

Two or more solvents may be mixed. Preferred is the solvent capable of uniformly dissolving the fluoropolyether-containing polymer having a hydrolyzable silyl group and/or partial hydrolytic condensate thereof or the fluoropolyether-containing polymer composition. When the fluoropolyether-containing polymer having a hydrolyzable silyl group and/or partial hydrolytic condensate thereof is dissolved in the solvent, the optimum concentration is not particularly limited and may be selected as appropriate depending on how to apply the surface treating agent. The polymer is typically dissolved in the solvent so as to provide a concentration of 0.01 to 30% by weight, preferably 0.02 to 25% by weight, more preferably 0.05 to 20% by weight.

In forming the water/oil repellent surface layer from the surface treating agent, any of well-known techniques such as brush coating, dipping (or immersion), spraying, and evaporation or physical vapor deposition (PVD) may be used. Inter alia, PVD, spraying or dipping is preferred. In case of PVD, the heating means used for evaporation deposition may be either resistance heating or electron beam heating and is not particularly limited.

The formation of the water/oil repellent surface layer is preferably followed by curing treatment. The curing treatment involves exposure to an environment at a temperature of 20 to 200°C and a relative humidity of up to 95% for at least 0.5 hour. The conditions for the curing treatment may be suitably adjusted depending on a particular technique for forming the water/oil repellent surface layer. For example, preferred conditions for direct coating (brush coating, dipping or spraying) include 60 to 150°C, up to 85% RH, and 30 minutes to 24 hours, and preferred conditions for evaporation deposition include 25 to 150°C, up to 85% RH, and 30 minutes to 24 hours.

The water/oil repellent surface layer typically has a film thickness of 0.1 to 100 nm, preferably 1 to 20 nm. The thickness of the water/oil repellent surface layer may be measured by the aforementioned XRR or spectral ellipsometry.

## EXAMPLES

Examples and Comparative Examples are given below for illustrating the invention although the invention is not limited thereto. In Examples, the number average molecular weight (Mn) is computed from a ratio of characteristic peak strengths in $^{19}$F-NMR spectroscopy.

[Comparative Example 1]

[Cleaning of plastic substrate]

A silicone hard coat polycarbonate (HC/PC) substrate (Lexan Margard by Sabic, size 100 mm × 50 mm × 3 mm thick) was washed with a kitchen neutral detergent and an acrylic sponge. Then the plastic substrate was thoroughly rinsed with deionized water. The plastic substrate was dried by ejecting compressed air to blow off water.

[Plasma cleaning of plastic substrate]

The HC/PC substrate as cleaned was treated on its surface with an oxygen/argon mixture plasma under the following conditions.

| | |
|---|---|
| Treatment device: | PDC510 (Yamato Scientific Co., Ltd.) |
| Oxygen gas flow rate: | 10 sccm (standard cubic centimeters) |
| Argon gas flow rate: | 100 sccm |
| Treating pressure: | 60 Pa |
| RF supply power: | 250 W |
| Treating time: | 30 seconds |

[Formation of silicon oxide underlayer by CVD method using OH radicals]

The CVD method described in Patent Document 14 (JP 6569831) was used to form a silicon oxide underlayer on the HC/PC substrate. Specifically, a silicon oxide underlayer having a film thickness of 5 nm and a film density of 2.0 g/cm$^3$ was formed under the following treatment conditions.

| | |
|---|---|
| Precursor material: | tetraethoxysilane |
| Substrate temperature: | 30°C |
| Treating gas (flow rate): | ozone gas (150 sccm) |
| | ethylene gas (50 sccm) |
| | tetraethoxysilane (1 sccm) |
| | nitrogen gas (15 sccm) |

The film thickness and film density of the silicon oxide underlayer were measured by the X-ray reflectometry. Specifically, the film thickness and density were determined by simulation fitting of the measured profile.

The measuring conditions are shown below.

| | |
|---|---|
| Analyzer: | SmartLab (Rigaku Corp.) |
| X-ray source: | rotating anode (Cu), output 45 kV, 200 mA |
| Incident optical system: | Ge (111) asymmetric beam compression crystal |
| Detector solar slit: | 5.0° |
| Slit: | incident side IS = 0.05 mm<br>detector side RS1 = 0.1 mm, RS2 = 0.1 mm |
| Scanning conditions: | scanning axis 2θ/ω<br>scanning speed 0.2°/min<br>step width 0.002° |

[Formation of water/oil repellent surface layer by physical vapor deposition (PVD)]

The silicon oxide underlayer-bearing HC/PC substrate was set in a vacuum evaporation system of resistance heating type (VTR-350M by ULVAC Inc.). A droplet (5 μL) of a surface treating agent was placed in the resistance heater chamber, which was evacuated. When the chamber was evacuated to or below an internal pressure of $3\times10^{-3}$ Pa, resistance heating was started. The power fed for resistance heating was adjusted such that the maximum evaporation rate measured by a quartz oscillator film thickness meter which was spaced ~20 cm apart from the resistance heater chamber might be 1.0 nm/sec. After the evaporation rate read by the quartz oscillator film thickness meter decreased to 0.1 nm/sec, resistance heating was continued for a further 100 seconds. After a standby time of 5 minutes for cooling, the chamber was opened to air. The HC/PC substrate having a fluoropolyether-containing polymer deposited thereon was obtained.

The HC/PC substrate having a fluoropolyether-containing polymer deposited thereon was allowed to stand in an environment of 25°C and RH 50% for 24 hours, during which the water/oil repellent surface layer was cured and fixed. The HC/PC substrate bearing a water/oil repellent surface layer of fluoropolyether-containing polymer having a film thickness of 10 nm was obtained.

The film thickness of the water/oil repellent surface layer was computed by quantitatively measuring the strength of X-ray fluorescence attributable to fluorine element by means of X-ray fluorescence spectrometer (Rigaku Inc., tradename X-ray fluorescence spectrometer Primini), and plotting on the calibration line.

[Preparation of surface treating agent]

The surface treating agent was prepared by dissolving Compound A (Mn 4,000) having the formula shown below in a fluorochemical solvent (Novec HFE-7200 by 3M) to a concentration of 20% by weight.

[Chem. 61]

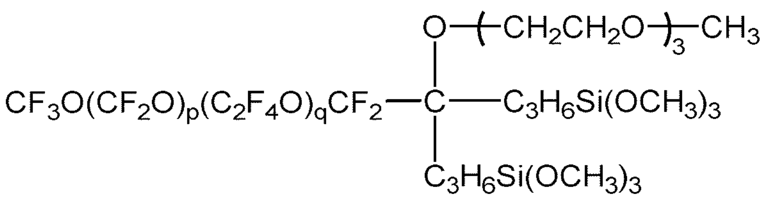

(A)

$$(p / q = 1.0,\ p + q = 46)$$

[Example 1]

A substrate bearing a water/oil repellent surface layer of fluoropolyether-containing polymer was prepared by the same procedure as in Comparative Example 1 except that the deposition time was adjusted such that the silicon oxide underlayer might have a film thickness of 100 nm.

[Example 2]

A substrate bearing a water/oil repellent surface layer of fluoropolyether-containing polymer was prepared by the same procedure as in Comparative Example 1 except that the deposition time was adjusted such that the silicon oxide underlayer might have a film thickness of 200 nm.

[Example 3]

A substrate bearing a water/oil repellent surface layer of fluoropolyether-containing polymer was prepared by the same procedure as in Comparative Example 1 except that the conditions for forming the silicon oxide underlayer were changed as below such that the silicon oxide underlayer might have a film thickness of 200 nm and a film density of 2.2 g/$cm^3$.

| | |
|---|---|
| Precursor material: | hexamethyldisilazane |
| Substrate temperature: | 150°C |
| Treating gas (flow rate): | ozone gas (200 sccm) |
| | ethylene gas (20 sccm) |
| | hexamethyldisilazane (5 sccm) |
| | nitrogen gas (15 sccm) |

[Comparative Example 2]

A substrate bearing a water/oil repellent surface layer of fluoropolyether-containing polymer was prepared by the same procedure as in Comparative Example 1 except that the silicon oxide underlayer was formed by the following method.

[Formation of silicon oxide underlayer using silica nano-particles]

A HC/PC substrate which had been subjected to washing and plasma cleaning as in Comparative Example 1 was dip coated with a water dispersion of silica nano-particles, forming a silicon oxide underlayer having a film thickness of 4 nm and a film density of 2.0 g/$cm^3$. The coating conditions are shown below.

| | |
|---|---|
| average particle size of silica nano-particles: | 2 nm |
| concentration of silica nano-particles: | 0.1 wt% |
| dipping time: | 30 sec |
| pull-up speed: | 3.0 mm/sec |
| drying conditions: | 150°C, 30 min |

[Comparative Example 3]

A substrate bearing a water/oil repellent surface layer of fluoropolyether-containing polymer was prepared by the same procedure as in Comparative Example 2 except that a silicon oxide underlayer having a film thickness of 10 nm was formed under the following dipping conditions.

| | |
|---|---|
| average particle size of silica nano-particles: | 2 nm |
| concentration of silica nano-particles: | 0.1 wt% |
| dipping time: | 30 sec |
| pull-up speed: | 0.5 mm/sec |
| drying conditions: | 150°C, 30 min |

[Comparative Example 4]

A substrate bearing a water/oil repellent surface layer of fluoropolyether-containing polymer was prepared by the same procedure as in Comparative Example 1 except that a silicon oxide underlayer was formed by the following method.

[Formation of silicon oxide underlayer using polysilazane]

A HC/PC substrate which had been subjected to washing and plasma cleaning as in Comparative Example 1 was spray coated with a perhydropolysilazane solution (Aquamica NP-140-01 by AZ Electronic Materials) and allowed to stand in an ambient atmosphere of 25°C and RH 85% for 24 hours for curing, forming a silicon oxide underlayer having a film thickness of 10 nm and a film density of 2.0 g/cm$^3$.

[Comparative Example 5]

A substrate bearing a water/oil repellent surface layer of fluoropolyether-containing polymer was prepared by the same procedure as in Comparative Example 4 except that the curing conditions for the silicon oxide underlayer were standing in an ambient atmosphere of 25°C and RH 40% for 24 hours.

[Example 4]

A substrate bearing a water/oil repellent surface layer of fluoropolyether-containing polymer was prepared by the same procedure as in Comparative Example 5 except that the silicon oxide underlayer had a film thickness of 100 nm.

[Comparative Example 6]

A substrate bearing a water/oil repellent surface layer of fluoropolyether-containing polymer was prepared by the same procedure as in Comparative Example 4 except that the curing conditions for silicon oxide underlayer are standing in ambient atmosphere at 25°C and RH 5% for 24 hours.

[Comparative Example 7]

A substrate bearing a water/oil repellent surface layer of fluoropolyether-containing polymer was prepared by the same procedure as in Comparative Example 6 except that the silicon oxide underlayer had a film thickness of 100 nm.

[Comparative Example 8]

A substrate bearing a water/oil repellent surface layer of fluoropolyether-containing polymer was prepared by the same procedure as in Comparative Example 1 except that the silicon oxide underlayer was formed by the following method.

[Formation of silicon oxide underlayer by physical vapor deposition (PVD)]

On a HC/PC substrate which had been subjected to washing and plasma cleaning as in Comparative Example 1, silicon oxide was evaporated by EB heating to form a silicon oxide underlayer having a film thickness of 5 nm and a film density of 2.3 g/cm$^3$. The deposition conditions are shown below.

| | |
|---|---|
| Evaporation source: | $SiO_2$ granules (2 mm) |
| Ultimate pressure: | $1 \times 10^{-3}$ Pa |
| Deposition rate: | 1 nm/sec |

[Comparative Example 9]

A substrate bearing a water/oil repellent surface layer of fluoropolyether-containing polymer was prepared by the same procedure as in Comparative Example 8 except that the silicon oxide underlayer had a film thickness of 100 nm.

[Comparative Example 10]

A substrate bearing a water/oil repellent surface layer of fluoropolyether-containing polymer was prepared by the same procedure as in Comparative Example 8 except that the silicon oxide underlayer had a film thickness of 200 nm.

[Comparative Example 11]

A substrate bearing a water/oil repellent surface layer of fluoropolyether-containing polymer was prepared by the same procedure as in Comparative Example 1 except that the silicon oxide underlayer was formed by the following method.

[Formation of silicon oxide underlayer by plasma-assisted CVD]

On a HC/PC substrate which had been subjected to washing and plasma cleaning as in Comparative Example 1, a silicon oxide underlayer was deposited by the plasma-assisted CVD method. Under the following treatment conditions, a silicon oxide underlayer having a film thickness of 10 nm and a film density of 2.4 g/$cm^3$ was formed.

| | |
|---|---|
| Precursor material: | $SiH_4$ |
| Substrate temperature: | 150°C |
| RF plasma source supply power: | 300 W |
| Treating pressure: | 150 Pa |
| Treating gas (flow rate ratio): | $SiH_4 : N_2O : H_2 = 1 : 30 : 180$ |

[Comparative Example 12]

A substrate bearing a water/oil repellent surface layer of fluoropolyether-containing polymer was prepared by the same procedure as in Comparative Example 11 except that the silicon oxide underlayer had a film thickness of 100 nm.

[Comparative Example 13]

A substrate bearing a water/oil repellent surface layer of fluoropolyether-containing polymer was prepared by the same procedure as in Comparative Example 11 except that the silicon oxide underlayer had a film thickness of 200 nm.

[Comparative Example 14]

A substrate bearing a water/oil repellent surface layer of fluoropolyether-containing polymer was prepared by the same procedure as in Comparative Example 1 except that the surface treating agent was prepared by dissolving Compound B (Mn 4,000) having the formula shown below in a fluorochemical solvent (Novec HFE-7200 by 3M) to a concentration of 20% by weight.

[Chem. 62]

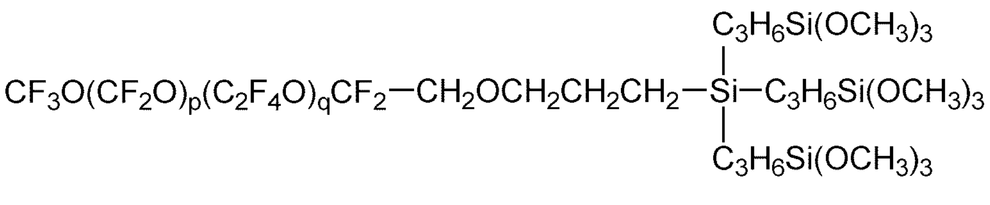

(B)

(p / q = 1.0, p + q = 42)

[Example 5]

A substrate bearing a water/oil repellent surface layer of fluoropolyether-containing polymer was prepared by the same procedure as in Example 2 except that the surface treating agent of Compound B was used.

[Example 6]

A substrate bearing a water/oil repellent surface layer of fluoropolyether-containing polymer was prepared by the same procedure as in Example 3 except that the surface treating agent of Compound B was used.

[Example 7]

A substrate bearing a water/oil repellent surface layer of fluoropolyether-containing polymer was prepared by the same procedure as in Example 4 except that the surface treating agent of Compound B was used.

[Comparative Example 15]

A substrate bearing a water/oil repellent surface layer of fluoropolyether-containing polymer was prepared by the same procedure as in Comparative Example 7 except that the surface treating agent of Compound B was used.

[Comparative Example 16]

A substrate bearing a water/oil repellent surface layer of fluoropolyether-containing polymer was prepared by the same procedure as in Comparative Example 10 except that the surface treating agent of Compound B was used.

[Comparative Example 17]

A substrate bearing a water/oil repellent surface layer of fluoropolyether-containing polymer was prepared by the same procedure as in Comparative Example 1 except that the surface treating agent was prepared by dissolving Compound C (Mn 4,000) having the formula shown below in a fluorochemical solvent (Novec HFE-7200 by 3M) to a concentration of 20% by weight.

[Chem. 63]

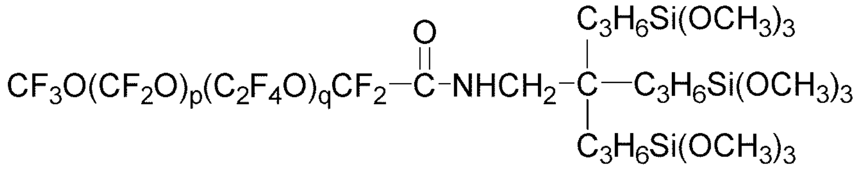

(C)

(p / q = 1.0, p + q = 42)

[Example 8]

A substrate bearing a water/oil repellent surface layer of fluoropolyether-containing polymer was prepared by the same procedure as in Example 2 except that the surface treating agent of Compound C was used.

[Example 9]

A substrate bearing a water/oil repellent surface layer of fluoropolyether-containing polymer was prepared by the same procedure as in Example 3 except that the surface treating agent of Compound C was used.

[Example 10]

A substrate bearing a water/oil repellent surface layer of fluoropolyether-containing polymer was prepared by the same procedure as in Example 4 except that the surface treating agent of Compound C was used.

[Comparative Example 18]

A substrate bearing a water/oil repellent surface layer of fluoropolyether-containing polymer was prepared by the same procedure as in Comparative Example 7 except that the surface treating agent of Compound C was used.

[Comparative Example 19]

A substrate bearing a water/oil repellent surface layer of fluoropolyether-containing polymer was prepared by the same procedure as in Comparative Example 10 except that the surface treating agent of Compound C was used.

[Comparative Example 20]

A substrate bearing a water/oil repellent surface layer of fluoropolyether-containing polymer was prepared by the same procedure as in Comparative Example 1 except that a hard coat polyimide film (100 mm × 50 mm × 0.1 mm thick) was used as the plastic substrate.

[Example 11]

A substrate bearing a water/oil repellent surface layer of fluoropolyether-containing polymer was prepared by the same procedure as in Comparative Example 20 except that the deposition time was adjusted such that the silicon oxide underlayer might have a film thickness of 100 nm.

[Example 12]

A substrate bearing a water/oil repellent surface layer of fluoropolyether-containing polymer was prepared by the same procedure as in Comparative Example 20 except that the deposition time was adjusted such that the silicon oxide underlayer might have a film thickness of 200 nm.

[Example 13]

A substrate bearing a water/oil repellent surface layer of fluoropolyether-containing polymer was prepared by the same procedure as in Comparative Example 20 except that the conditions for forming the silicon oxide underlayer were changed as below such that the silicon oxide underlayer might have a film thickness of 200 nm and a film density of 2.2 g/cm$^3$.

| | |
|---|---|
| Precursor material: | hexamethyldisilazane |
| Substrate temperature: | 150°C |
| Treating gas (flow rate): | ozone gas (200 sccm) |
| | ethylene gas (20 sccm) |
| | hexamethyldisilazane (5 sccm) |
| | nitrogen gas (15 sccm) |

[Comparative Example 21]

A substrate bearing a water/oil repellent surface layer of fluoropolyether-containing polymer was prepared by the same procedure as in Comparative Example 20 except that the silicon oxide underlayer was formed by the following method.

[Formation of silicon oxide underlayer using polysilazane]

A HC/PI substrate which had been subjected to washing and plasma cleaning as in Comparative Example 20 was spray coated with a perhydropolysilazane solution (Aquamica NP-140-01 by AZ Electronic Materials) and allowed to stand in an ambient atmosphere of 25°C and RH 40% for 24 hours for curing, forming a silicon oxide underlayer having a film thickness of 10 nm and a film density of 1.8 g/cm$^3$.

[Example 14]

A substrate bearing a water/oil repellent surface layer of fluoropolyether-containing polymer was prepared by the same procedure as in Comparative Example 21 except that the silicon oxide underlayer had a film thickness of 100 nm.

[Comparative Example 22]

A substrate bearing a water/oil repellent surface layer of fluoropolyether-containing polymer was prepared by the same procedure as in Comparative Example 21 except that the curing conditions for the silicon oxide underlayer were standing in an ambient atmosphere of 25°C and RH 5% for 24 hours.

[Comparative Example 23]

A substrate bearing a water/oil repellent surface layer of fluoropolyether-containing polymer was prepared by the same procedure as in Comparative Example 22 except that the silicon oxide underlayer had a film thickness of 100 nm.

[Comparative Example 24]

A substrate bearing a water/oil repellent surface layer of fluoropolyether-containing polymer was prepared by the same procedure as in Comparative Example 20 except that the silicon oxide underlayer was formed by the following method.

[Formation of silicon oxide underlayer by physical vapor deposition (PVD)]

On a HC/PI substrate which had been subjected to washing and plasma cleaning as in Comparative Example 20, a silicon oxide underlayer having a film thickness of 5 nm and a film density of 2.3 g/$cm^3$ was deposited by electron beam evaporation of silicon oxide. The deposition conditions are shown below.

| | |
|---|---|
| Evaporation source: | $SiO_2$ granules (2 mm) |
| Ultimate pressure: | $1 \times 10^{-3}$ Pa |
| Deposition rate: | 1 nm/sec |

[Comparative Example 25]

A substrate bearing a water/oil repellent surface layer of fluoropolyether-containing polymer was prepared by the same procedure as in Comparative Example 24 except that the silicon oxide underlayer had a film thickness of 100 nm.

[Comparative Example 26]

A substrate bearing a water/oil repellent surface layer of fluoropolyether-containing polymer was prepared by the same procedure as in Comparative Example 20 except that the silicon oxide underlayer was formed by the following method.

[Formation of silicon oxide underlayer by plasma-assisted CVD]

On a HC/PI substrate which had been subjected to washing and plasma cleaning as in Comparative Example 20, a silicon oxide underlayer was deposited by the plasma-assisted CVD method. Under the following treatment conditions, a silicon oxide underlayer having a film thickness of 10 nm and a film density of 2.4 g/$cm^3$ was formed.

| | |
|---|---|
| Precursor material: | $SiH_4$ |
| Substrate temperature: | 150°C |
| RF plasma source supply power: | 300 W |
| Treating pressure: | 150 Pa |
| Treating gas (flow rate ratio): | $SiH_4$ : $N_2O$ : $H_2$ = 1 : 30 : 180 |

[Comparative Example 27]

A substrate bearing a water/oil repellent surface layer of fluoropolyether-containing polymer was prepared by the same procedure as in Comparative Example 26 except that the silicon oxide underlayer had a film thickness of 100 nm.

[Comparative Example 28]

A substrate bearing a water/oil repellent surface layer of fluoropolyether-containing polymer was prepared by the same procedure as in Comparative Example 20 except that the surface treating agent of Compound B was used.

[Example 15]

A substrate bearing a water/oil repellent surface layer of fluoropolyether-containing polymer was prepared by the same procedure as in Example 11 except that the surface treating agent of Compound B was used.

[Example 16]

A substrate bearing a water/oil repellent surface layer of fluoropolyether-containing polymer was prepared by the same procedure as in Example 12 except that the surface treating agent of Compound B was used.

[Example 17]

A substrate bearing a water/oil repellent surface layer of fluoropolyether-containing polymer was prepared by the same procedure as in Example 14 except that the surface treating agent of Compound B was used.

[Comparative Example 29]

A substrate bearing a water/oil repellent surface layer of fluoropolyether-containing polymer was prepared by the same procedure as in Comparative Example 23 except that the surface treating agent of Compound B was used.

[Comparative Example 30]

A substrate bearing a water/oil repellent surface layer of fluoropolyether-containing polymer was prepared by the same procedure as in Comparative Example 25 except that the surface treating agent of Compound B was used.

[Comparative Example 31]

A substrate bearing a water/oil repellent surface layer of fluoropolyether-containing polymer was prepared by the same procedure as in Comparative Example 20 except that the surface treating agent of Compound C was used.

[Example 18]

A substrate bearing a water/oil repellent surface layer of fluoropolyether-containing polymer was prepared by the same procedure as in Example 11 except that the surface treating agent of Compound C was used.

[Example 19]

A substrate bearing a water/oil repellent surface layer of fluoropolyether-containing polymer was prepared by the same procedure as in Example 12 except that the surface treating agent of Compound C was used.

[Example 20]

A substrate bearing a water/oil repellent surface layer of fluoropolyether-containing polymer was prepared by the same procedure as in Example 14 except that the surface treating agent of Compound C was used.

[Comparative Example 32]

A substrate bearing a water/oil repellent surface layer of fluoropolyether-containing polymer was prepared by

the same procedure as in Comparative Example 23 except that the surface treating agent of Compound C was used.

[Comparative Example 33]

A substrate bearing a water/oil repellent surface layer of fluoropolyether-containing polymer was prepared by the same procedure as in Comparative Example 25 except that the surface treating agent of Compound C was used.

Evaluation of initial water repellency

Using a contact angle meter Drop Master (Kyowa Interface Science Co., Ltd.), the substrate having the silicon oxide underlayer and the water/oil repellent surface layer prepared above was measured for a contact angle with water (indicative of water repellency) on the water/oil repellent surface layer (droplet 2 μl, temperature 25°C, relative humidity 40%). The rating is excellent (◎) for a contact angle with water of 112° or greater, good (○) for a contact angle of 108° to less than 112°, fair (△) for a contact angle of 100° to less than 108°, and poor (×) for a contact angle of less than 100°, with the results shown in Tables 1 and 2.
All the samples of Examples and Comparative Examples had an initial contact angle with water of 112° or greater, indicating excellent water repellency.

Evaluation of glide

Using a surface property tester (Type 14FW by Shinto Scientific Co., Ltd.), the substrate having the silicon oxide underlayer and the water/oil repellent surface layer prepared above was measured for a coefficient of dynamic friction. The surface was rubbed with a non-woven fabric (Bemcot M-3II by Asahi Kasei Corp.) at a load of 100 gf/cm$^2$ and a rubbing speed of 500 mm/min. Provided that the coefficient of dynamic friction is an index for evaluating glide resistance, the rating is excellent (◎) for a coefficient of less than 0.05, good (○) for a coefficient of 0.05 to less than 0.1, fair (△) for a coefficient of 0.1 to less than 0.2, and poor (×) for a coefficient of 0.2 or greater, with the results shown in Tables 1 and 2. The test environment conditions include 25°C and RH 40%.
The samples of Examples 1 to 7, 11 to 17 and Comparative Examples 1 to 16, 20 to 30 had a coefficient of dynamic friction of less than 0.05, indicating excellent glide.

Evaluation of abrasion durability

[Frictional abrasion test using non-woven fabric]

Using a reciprocal abrasion tester (Type 40 by Shinto Scientific Co., Ltd.), the HC/PC substrate having the silicon oxide underlayer and the water/oil repellent surface layer prepared above was tested under the following conditions.

| | |
|---|---|
| Rubbing material: | non-woven fabric (Bemcot M-3II by Asahi Kasei Corp.) |
| Load: | 1 kgf |
| Reciprocal distance: | 40 mm |
| Reciprocal moving speed: | 60 cycles/min |
| Total number of friction cycles: | 3,000 cycles |

Every 500 reciprocal friction cycles, the frictionally abraded portion was measured for a contact angle with water. Provided that the number of reciprocal friction cycles within which a contact angle with water of 100° or greater is maintained is the index of non-woven fabric abrasion durability, the sample is rated excellent (◎) for an index of abrasion durability of 3,000 cycles or greater, good (○) for an index of abrasion durability of 2,000 cycles to less than 3,000 cycles, fair (△) for an index of abrasion durability of 1,000 cycles to less than 2,000 cycles, and poor (×) for an index of abrasion durability of less than 1,000 cycles, with the results shown in Table 1. The test environment conditions include 25°C and RH 40%.

[Evaluation of eraser abrasion durability]

Using a reciprocal abrasion tester (Type 40 by Shinto Scientific Co., Ltd.), the HC/PI substrate having the silicon oxide underlayer and the water/oil repellent surface layer prepared above was tested under the following conditions.

| | |
|---|---|
| Rubbing material: | eraser (Minoan Co., diameter 6 mm) |

(continued)

| | |
|---|---|
| Load: | 1 kgf |
| Reciprocal distance: | 40 mm |
| Reciprocal moving speed: | 40 cycles/min |
| Total number of friction cycles: | 1,000 cycles |

Every 100 reciprocal friction cycles, the frictionally abraded portion was measured for a contact angle with water. Provided that the number of reciprocal friction cycles within which a contact angle with water of 100° or greater is maintained is the index of eraser abrasion durability, the sample is rated excellent (◎) for an index of eraser abrasion durability of 1,000 cycles or greater, good (○) for an index of eraser abrasion durability of 500 cycles to less than 1,000 cycles, fair (△) for an index of eraser abrasion durability of 200 cycles to less than 500 cycles, and poor (×) for an index of eraser abrasion durability of less than 200 cycles, with the results shown in Table 2. The test environment conditions include 25°C and RH 40%.

[Table 1]

| | Plastic substrate | Silicon oxide underlayer | | | Water/oil repellent surface layer | | Initial water repellency | Gliding property | Non-woven fabric abrasion durability |
|---|---|---|---|---|---|---|---|---|---|
| | | Formation method | Film thickness (nm) | Film density (g/cm$^3$) | Compound | Film thickness (nm) | | | |
| Comparative Example 1 | HC/PC | CVD | 5 | 2.0 | (A) | 10 | ◎ | ◎ | × |
| Example 1 | HC/PC | CVD | 100 | 2.0 | (A) | 10 | ◎ | ◎ | ○ |
| Example 2 | HC/PC | CVD | 200 | 2.0 | (A) | 9 | ◎ | ◎ | ◎ |
| Example 3 | HC/PC | CVD | 200 | 22 | (A) | 9 | ◎ | ◎ | ◎ |
| Comparative Example 2 | HC/PC | silica nano-particles | 4 | 2.0 | (A) | 10 | ◎ | ◎ | × |
| Comparative Example 3 | HC/PC | silica nano-particles | 10 | 2.0 | (A) | 10 | ◎ | ◎ | × |
| Comparative Example 4 | HC/PC | polysilazane | 10 | 2.0 | (A) | 10 | ◎ | ◎ | × |
| Comparative Example 5 | HC/PC | polysilazane | 10 | 1.8 | (A) | 8 | ◎ | ◎ | × |
| Example 4 | HC/PC | polysilazane | 100 | 1.8 | (A) | 8 | ◎ | ◎ | ○ |
| Comparative Example 6 | HC/PC | polysilazane | 10 | 1.7 | (A) | 9 | ◎ | ◎ | × |
| Comparative Example 7 | HC/PC | polysilazane | 100 | 1.7 | (A) | 9 | ◎ | ◎ | △ |
| Comparative Example 8 | HC/PC | PVD | 5 | 23 | (A) | 10 | ◎ | ◎ | × |
| Comparative Example 9 | HC/PC | PVD | 100 | 23 | (A) | 10 | ◎ | ◎ | × |
| Comparative Example 10 | HC/PC | PVD | 200 | 23 | (A) | 10 | ◎ | ◎ | △ |

(continued)

| | Plastic substrate | Silicon oxide underlayer | | | Water/oil repellent surface layer | | Initial water repellency | Gliding property | Non-woven fabric abrasion durability |
|---|---|---|---|---|---|---|---|---|---|
| | | Formation method | Film thickness (nm) | Film density (g/cm$^3$) | Compound | Film thickness (nm) | | | |
| Comparative Example 11 | HC/PC | plasma-assisted CVD | 10 | 2.4 | (A) | 10 | ◎ | ◎ | × |
| Comparative Example 12 | HC/PC | plasma-assisted CVD | 100 | 2.4 | (A) | 9 | ◎ | ◎ | × |
| Comparative Example 13 | HC/PC | plasma-assisted CVD | 200 | 2.4 | (A) | 9 | ◎ | ◎ | △ |
| Comparative Example 14 | HC/PC | CVD | 5 | 2.0 | (B) | 9 | ◎ | ◎ | × |
| Example 5 | HC/PC | CVD | 200 | 2.0 | (B) | 9 | ◎ | ◎ | ○ |
| Example 6 | HC/PC | CVD | 200 | 22 | (B) | 9 | ◎ | ◎ | ◎ |
| Example 7 | HC/PC | polysilazane | 100 | 1.8 | (B) | 8 | ◎ | ◎ | ○ |
| Comparative Example 15 | HC/PC | polysilazane | 100 | 1.7 | (B) | 8 | ◎ | ◎ | △ |
| Comparative Example 16 | HC/PC | PVD | 200 | 23 | (B) | 8 | ◎ | ◎ | × |
| Comparative Example 17 | HC/PC | CVD | 5 | 2.0 | (C) | 10 | ◎ | △ | × |
| Example 8 | HC/PC | CVD | 200 | 2.0 | (C) | 10 | ◎ | △ | ◎ |
| Example 9 | HC/PC | CVD | 200 | 22 | (C) | 10 | ◎ | △ | ◎ |
| Example 10 | HC/PC | polysilazane | 100 | 1.8 | (C) | 8 | ◎ | △ | ○ |
| Comparative Example 18 | HC/PC | polysilazane | 100 | 1.7 | (C) | 8 | ◎ | △ | △ |
| Comparative Example 19 | HC/PC | PVD | 200 | 23 | (C) | 8 | ◎ | △ | △ |

[Table 2]

| | Plastic substrate | Silicon oxide underlayer | | | Water/oil repellent surface layer | | Initial water repellency | Gliding property | Eraser abrasion durability |
|---|---|---|---|---|---|---|---|---|---|
| | | Formation method | Film thickness (nm) | Film density (g/cm$^3$) | Compound | Film thickness (nm) | | | |
| Comparative Example 20 | HC/PI | CVD | 5 | 2.0 | (A) | 10 | ◎ | ◎ | × |
| Example 11 | HC/PI | CVD | 100 | 2.0 | (A) | 10 | ◎ | ◎ | ○ |
| Example 12 | HC/PI | CVD | 200 | 2.0 | (A) | 9 | ◎ | ◎ | ◎ |
| Example 13 | HC/PI | CVD | 200 | 22 | (A) | 9 | ◎ | ◎ | ◎ |
| Comparative Example 21 | HC/PI | polysilazane | 10 | 1.8 | (A) | 8 | ◎ | ◎ | × |
| Example 14 | HC/PI | polysilazane | 100 | 1.8 | (A) | 8 | ◎ | ◎ | ○ |
| Comparative Example 22 | HC/PI | polysilazane | 10 | 1.7 | (A) | 9 | ◎ | ◎ | × |
| Comparative Example 23 | HC/PI | polysilazane | 100 | 1.7 | (A) | 9 | ◎ | ◎ | Δ |
| Comparative Example 24 | HC/PI | PVD | 5 | 23 | (A) | 10 | ◎ | ◎ | × |
| Comparative Example 25 | HC/PI | PVD | 100 | 23 | (A) | 10 | ◎ | ◎ | × |
| Comparative Example 26 | HC/PI | plasma-assisted CVD | 10 | 2.4 | (A) | 10 | ◎ | ◎ | × |
| Comparative Example 27 | HC/PI | plasma-assisted CVD | 100 | 2.4 | (A) | 10 | ◎ | ◎ | × |
| Comparative Example 28 | HC/PI | CVD | 5 | 2.0 | (B) | 9 | ◎ | ◎ | × |
| Example 15 | HC/PI | CVD | 100 | 2.0 | (B) | 9 | ◎ | ◎ | ○ |
| Example 16 | HC/PI | CVD | 200 | 2.0 | (B) | 9 | ◎ | ◎ | ○ |
| Example 17 | HC/PI | polysilazane | 100 | 1.8 | (B) | 8 | ◎ | ◎ | ○ |

(continued)

| | Plastic substrate | Silicon oxide underlayer | | | Water/oil repellent surface layer | | Initial water repellency | Gliding property | Eraser abrasion durability |
|---|---|---|---|---|---|---|---|---|---|
| | | Formation method | Film thickness (nm) | Film density ($g/cm^3$) | Compound | Film thickness (nm) | | | |
| Comparative Example 29 | HC/PI | polysilazane | 100 | 1.7 | (B) | 8 | ◎ | ◎ | × |
| Comparative Example 30 | HC/PI | PVD | 100 | 23 | (B) | 8 | ◎ | ◎ | × |
| Comparative Example 31 | HC/PI | CVD | 5 | 2.0 | (C) | 10 | ◎ | Δ | × |
| Example 18 | HC/PI | CVD | 100 | 2.0 | (C) | 10 | ◎ | Δ | ○ |
| Example 19 | HC/PI | CVD | 200 | 2.0 | (C) | 10 | ◎ | Δ | ○ |
| Example 20 | HC/PI | polysilazane | 100 | 1.8 | (C) | 8 | ◎ | Δ | ○ |
| Comparative Example 32 | HC/PI | polysilazane | 100 | 1.7 | (C) | 8 | ◎ | Δ | × |
| Comparative Example 33 | HC/PI | PVD | 100 | 23 | (C) | 8 | ◎ | Δ | × |

## Claims

1. An article comprising a plastic substrate, an underlayer formed mainly of silicon oxide on the outer surface of the plastic substrate, and a water/oil repellent surface layer formed on the outer surface of the underlayer, wherein the silicon oxide underlayer has a film density of 1.8 to 2.2 g/cm$^3$ and a film thickness of 80 to 300 nm, the water/oil repellent surface layer is based on a cured product of a fluoropolyether-containing polymer having a hydrolyzable silyl group and/or a partial hydrolytic condensate thereof, and the fluoropolyether-containing polymer having a hydrolyzable silyl group contains at least one fluoropolyether-containing polymer having the formula (1), (4) or (7):
[Chem. 1]

$$A^1\text{-Rf-D} \qquad (1)$$

wherein Rf is a divalent polyfluorooxyalkylene structure-containing group: $-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, p, q, r, s, t, and u are each independently an integer of 0 to 150, the sum of p, q, r, s, t, and u is an integer of 1 to 250, each unit may be straight or branched, the repeating units in parentheses with subscripts p, q, r, s, t, and u may be randomly arranged, $A^1$ is a monovalent fluorinated hydrocarbon group which is terminated with $CF_3$- or $CF_2H$- and may contain oxygen, or D, D is independently a monovalent group having the formula (2):
[Chem. 2]

$$\text{-Q-Z(W)}_\alpha \qquad (2)$$

wherein Q is a single bond or a divalent organic group, Z is a tri- to octavalent group, $\alpha$ is an integer of 2 to 7, W is independently a monovalent hydrolyzable silyl-containing group having the formula (3):

[Chem. 3]

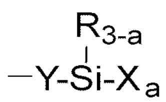
(3)

wherein R is a $C_1$-$C_4$ alkyl group or phenyl group, X is independently a hydrolyzable group, a is 2 or 3, Y is a single bond or a divalent hydrocarbon group which may contain at least one moiety selected from fluorine, silicon and siloxane bond,
[Chem. 4]

$$A^2\text{-Rf-G} \qquad (4)$$

wherein Rf is as defined above, $A^2$ is a monovalent fluorinated hydrocarbon group which is terminated with $CF_3$- or $CF_2H$- and may contain oxygen, or G, G is independently a monovalent group having the formula (5):

[Chem. 5]

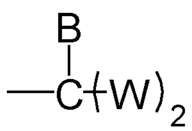
(5)

wherein W is as defined above, B is hydrogen or -OS, S is hydrogen, a $C_1$-$C_{10}$ monovalent hydrocarbon group, or a monovalent group having the formula (6):

[Chem. 6]

$$-T-(LO)_l-E \qquad (6)$$

wherein T is a single bond or divalent group, L is independently a $C_1$-$C_4$ divalent hydrocarbon group, E is a $C_1$-$C_6$ monovalent hydrocarbon group or W, l is an integer of 0 to 20,
[Chem. 7]

$A^3$-Rf-J (7)

wherein Rf is as defined above, $A^3$ is a monovalent fluorinated hydrocarbon group which is terminated with $CF_3$- or $CF_2H$- and may contain oxygen, or J, J is independently a monovalent group having the formula (8):

[Chem. 8]

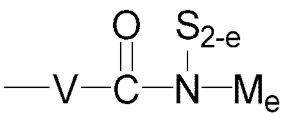

(8)

wherein S is as defined above, V is a single bond or a $C_2$-$C_{15}$ divalent hydrocarbon group which may contain an ether bond, M is independently a monovalent group having the formula (9):

[Chem. 9]

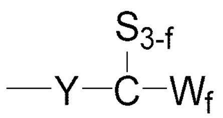

(9)

wherein Y, S, and W are as defined above, f is an integer of 1 to 3, and e is 1 or 2, J containing at least two W.

2. The article of claim 1 wherein in formula (2), Q is a $C_1$-$C_{15}$ substituted or unsubstituted divalent hydrocarbon group which may contain at least one bond selected from the group consisting of amide bond, ether bond, ester bond, sulfide bond, urethane bond, siloxane bond, triazine bond, diorganosilylene moiety, silphenylene bond and silalkylene bond, and Z is a tri- to octavalent group selected from silicon, nitrogen, and tri- to octavalent organopolysiloxane residues containing a siloxane bond.

3. The article of claim 1 wherein in formula (6), T is a single bond or a $C_2$-$C_{20}$ divalent hydrocarbon group which may contain at least one bond selected from the group consisting of silicon, siloxane bond, silalkylene bond, silarylene bond, and diorganosilylene moiety, a divalent siloxane bond, silalkylene group or diorganosilylene group.

4. The article of any one of claims 1 to 3 wherein the water/oil repellent surface layer contains a cured product of at least one fluoropolyether-containing polymer having the formula (1), (4) or (7), and/or a partial hydrolytic condensate thereof, and a fluoropolyether-containing polymer having the formula (10):
[Chem. 10]

$A^4$-Rf-$A^4$ (10)

wherein Rf is a divalent polyfluorooxyalkylene structure-containing group:

$-C_dF_{2d}-O-(CF_2O)_p(C_2F_4O)_q(C_3F_6O)_r(C_4F_8O)_s(C_5F_{10}O)_t(C_6F_{12}O)_u-C_dF_{2d}-$ wherein d is an integer of 0 to 5 independently for each unit, p, q, r, s, t, and u are each independently an integer of 0 to 150, the sum of p, q, r, s, t, and u is an integer of 1 to 250, each unit may be straight or branched, the repeating units in parentheses with subscripts p, q, r, s, t, and u may be randomly arranged, and $A^4$ is independently a monovalent fluorinated hydrocarbon group which is terminated with $CF_3$- or $CF_2H$- and may contain oxygen, or $-OR^3$, $-COOR^3$ or $-PO(OR^3)_2$ wherein $R^3$ is hydrogen or a $C_1$-$C_{10}$ monovalent hydrocarbon group, and/or a partial (hydrolytic) condensate thereof.

**5.** The article of any one of claims 1 to 4 wherein the water/oil repellent surface layer is formed by a physical vapor deposition (PVD) method, spraying method or dipping method.

**6.** The article of any one of claims 1 to 5 wherein the plastic substrate has been pretreated by wet cleaning and/or plasma cleaning.

## INTERNATIONAL SEARCH REPORT

International application No.
**PCT/JP2022/028769**

**A. CLASSIFICATION OF SUBJECT MATTER**

***B32B 9/00***(2006.01)i; ***B32B 27/30***(2006.01)i; ***C08G 65/323***(2006.01)i; ***C08G 65/328***(2006.01)i
FI: B32B27/30 D; B32B9/00 A; C08G65/323; C08G65/328

According to International Patent Classification (IPC) or to both national classification and IPC

**B. FIELDS SEARCHED**

Minimum documentation searched (classification system followed by classification symbols)

B32B1/00-B32B43/00;C03C15/00-C03C23/00;C08G65/00-C08G67/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2019/035271 A1 (SHIN-ETSU CHEMICAL CO., LTD.) 21 February 2019 (2019-02-21) claims, paragraphs [0013], [0057]-[0071], examples, tables 1-3 | 1-6 |
| A | JP 2010-285574 A (KONICA MINOLTA HOLDINGS INC) 24 December 2010 (2010-12-24) | 1–6 |
| A | WO 2016/190047 A1 (DAIKIN IND LTD) 01 December 2016 (2016-12-01) | 1–6 |
| A | WO 2019/187337 A1 (MEIDENSHA ELECTRIC MFG CO LTD) 03 October 2019 (2019-10-03) | 1–6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 October 2022** | **18 October 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/028769**

| Patent document cited in search report | Publication date (day/month/year) | Patent family member(s) | Publication date (day/month/year) |
|---|---|---|---|
| WO 2019/035271 A1 | 21 February 2019 | US 2021/0130545 A1<br>claims, paragraphs [0038], [0102]-[0127], examples, tables 1-3<br>CN 111032337 A<br>KR 10-2020-0040786 A<br>TW 201920507 A | |
| JP 2010-285574 A | 24 December 2010 | (Family: none) | |
| WO 2016/190047 A1 | 01 December 2016 | KR 10-2018-0001556 A<br>CN 107614257 A | |
| WO 2019/187337 A1 | 03 October 2019 | US 2021/0028011 A1<br>KR 10-2020-0111807 A<br>CN 111902564 A<br>TW 201942407 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6260579 B
- JP 6828744 B
- JP 5761305 B
- JP 6451279 B
- JP 6741074 B
- JP 6617853 B
- WO 2014097388 A
- JP 2020132498 A
- JP 2020090652 A
- JP 5655215 B
- JP 6601492 B
- JP 5494656 B
- WO 2019035271 A
- JP 6569831 B
- JP 2011116947 A
- JP 2007197425 A
- JP 2007297589 A
- JP 2007297543 A
- JP 2008088412 A
- JP 2008144144 A
- JP 2010031184 A
- JP 2010047516 A
- JP 2011178835 A
- JP 2014084405 A
- JP 2014105235 A
- JP 2013253228 A
- JP 2014218639 A
- WO 2013121984 A
- JP 2007011033 A
- JP 2014218635 A